(19) **Europäisches Patentamt**
**European Patent Office**
**Office européen des brevets**

(11) **EP 4 518 164 A1**

(12) **EUROPEAN PATENT APPLICATION**
published in accordance with Art. 153(4) EPC

(43) Date of publication:
**05.03.2025 Bulletin 2025/10**

(51) International Patent Classification (IPC):
***H03M 13/13*** (2006.01)

(21) Application number: **23810763.5**

(52) Cooperative Patent Classification (CPC):
**H03M 13/09; H03M 13/13; H04L 1/00**

(22) Date of filing: **28.04.2023**

(86) International application number:
**PCT/CN2023/091493**

(87) International publication number:
**WO 2023/226690 (30.11.2023 Gazette 2023/48)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **23.05.2022 CN 202210564600**

(71) Applicant: **Huawei Technologies Co., Ltd. Shenzhen, Guangdong 518129 (CN)**

(72) Inventors:
• **WANG, Xianbin**
  **Shenzhen, Guangdong 518129 (CN)**
• **ZHANG, Huazi**
  **Shenzhen, Guangdong 518129 (CN)**
• **QIN, Kangjian**
  **Shenzhen, Guangdong 518129 (CN)**
• **TONG, Jiajie**
  **Shenzhen, Guangdong 518129 (CN)**
• **LI, Rong**
  **Shenzhen, Guangdong 518129 (CN)**
• **WANG, Jun**
  **Shenzhen, Guangdong 518129 (CN)**

(74) Representative: **MERH-IP Matias Erny Reichl Hoffmann**
**Patentanwälte PartG mbB**
**Paul-Heyse-Straße 29**
**80336 München (DE)**

(54) **CODING AND DECODING METHOD AND APPARATUS**

(57)    This application relates to the field of communication technologies, and discloses an encoding method, a decoding method, and an apparatus, to implement joint source-channel coding based on a systematic polar code, and reduce encoding complexity and improve encoding flexibility by introducing bit position mapping. The method includes: performing polar encoding on an information bit sequence based on a target code length E, to determine an encoded bit sequence, where the polar encoding includes N first bit positions and N second bit positions that correspond to a polarization transformation matrix; the N second bit positions include a system bit position set A and a non-system bit position set $M^A$, and the N first bit positions include a frozen bit position set B and a non-frozen bit position set $M^B$; there is a subset C in B, there is a subset D in $M^B$, and bit positions in C and D are mapped to each other; and C is determined based on a bit position index intersection set of B and A, and D is determined based on a bit position index intersection set of $M^B$ and $M^A$; and performing rate matching on the encoded bit sequence to obtain a target encoded bit sequence.

```
Encoding device                                    Decoding device

S701: The encoding device
obtains an information bit
sequence

S702: Perform polar encoding on
the information bit sequence based
on a target code length E or a code
rate R, to determine an encoded
bit sequence

S703: Perform rate matching on
the encoded bit sequence to obtain
a target encoded bit sequence

        S704: The encoding device outputs the
        target encoded bit sequence, and
        correspondingly, the decoding device
        obtains a to-be-decoded symbol sequence

                                        S705: Perform polar decoding on the
                                        to-be-decoded symbol sequence
                                        based on the code rate R or a length
                                        K of a system bit sequence and an
                                        LLR corresponding to a system bit
                                        position, to determine the
                                        information bit sequence
```

FIG. 7

Processed by Luminess, 75001 PARIS (FR)

**Description**

**CROSS-REFERENCE TO RELATED APPLICATIONS**

This application claims priority to Chinese Patent Application No. 202210564600.5, filed with the China National Intellectual Property Administration on May 23, 2022 and entitled "ENCODING METHOD, DECODING METHOD, AND APPARATUS", which is incorporated herein by reference in its entirety.

**TECHNICAL FIELD**

Embodiments of this application relate to the field of communication technologies, and in particular, to an encoding method, a decoding method, and an apparatus.

**BACKGROUND**

In a 5th generation (5th generation, 5G) mobile communication system, three most typical communication scenarios include enhanced mobile broadband (enhanced mobile broadband, eMBB), massive machine type communication (massive machine type communication, mMTC), and ultra-reliable low-latency communication (ultra-reliable low-latency communication, URLLC). As a basic radio access technology, channel coding is one of important research objects to meet a 5G communication requirement. A polar code (polar code) is selected as a control channel coding scheme in a 5G standard. The polar code may also be referred to as a polar code, and is the first and only known channel coding scheme that can be strictly proved to "achieve" a Shannon channel capacity. For different code lengths, particularly for limited codes, performance of the polar code is much better than that of a Turbo code and a low density parity check (low density parity check, LDPC) code. In addition, the polar code has low computational complexity in terms of encoding and decoding. These advantages enable the polar code to have a great development and application prospect in 5G.

A systematic polar code is a polar code in which information bits are directly carried in system bit positions on a codeword side. In comparison with a non-systematic polar code, the systematic polar code has advantages such as better bit error ratio (bit error ratio, BER) performance and more convenient concatenation with another code. Therefore, how to implement joint source-channel coding (joint source-channel coding, JSCC) based on the systematic polar code, to enable the joint source-channel coding to also have the advantages of the systematic polar code is a problem worth considering. In addition, during encoding of the systematic polar code, because a position relationship between a system bit position and a frozen bit position is mutual coupling, an encoding process needs to be serially performed, or a non-systematic polar code encoding process needs to be performed in parallel for a plurality of times. Consequently, there are problems of high encoding complexity and insufficient flexibility, and these problems need to be resolved.

**SUMMARY**

Embodiments of this application provide an encoding method, a decoding method, and an apparatus, to implement joint source-channel coding based on a systematic polar code, and decouple a system bit position and a frozen bit position in the systematic polar code by introducing bit position mapping. This brings larger encoding design space, so that encoding complexity is reduced, and encoding flexibility is improved.

According to a first aspect, an embodiment of this application provides an encoding method. The method includes: obtaining an information bit sequence, where a length of the information bit sequence is K; performing polar encoding on the information bit sequence based on a target code length E or a code rate R, to determine an encoded bit sequence, where a systematic polar code on which polar encoding is performed includes a polarization transformation matrix and N first bit positions and N second bit positions that correspond to the polarization transformation matrix; the N second bit positions include a system bit position set A and a non-system bit position set $M^A$, and the N first bit positions include a frozen bit position set B and a non-frozen bit position set $M^B$; there is a frozen bit position subset C in B, there is a non-frozen bit position subset D in $M^B$, and a frozen bit position in C and a non-frozen bit position in D are mapped to each other; C is determined based on a bit position index intersection set of B and A, and D is determined based on a bit position index intersection set of $M^B$ and $M^A$; and a length of the encoded bit sequence is N, and R is equal to K/E; and performing rate matching on the encoded bit sequence to obtain a target encoded bit sequence, where a length of the target encoded bit sequence is E, and a set of bit positions in the target encoded bit sequence is a subset of $M^A$.

The foregoing encoding method may be performed by an encoding device such as a network device or a terminal device, or may be performed by a component (such as a processor, a chip, or a chip system) of the encoding device, or may be implemented by a logical module or software that can implement all or some functions of the encoding device.

In addition, it should be understood that, for the systematic polar code, a system bit position may be for carrying an information bit sequence, and a total quantity of system bit positions and frozen bit positions is equal to a code length N of the systematic polar code. Therefore, in this embodiment of this application, A includes K system bit positions, B includes N-K frozen bit positions, $M^A$ includes N-K non-system bit positions, and $M^B$ includes K non-frozen bit positions.

According to the foregoing method, encoding and decoding may be performed in a manner of the systematic polar code. In addition, for a scenario in which joint source-channel coding has a special prior distribution source, values of some or all of non-system bit positions in corresponding $M^A$ may be used as output. This not only retains advantages of the systematic polar code, but also can adapt to different prior distributions of sources, so that transmission efficiency is improved. In addition, a mutual mapping relationship between the frozen bit position in C and the non-frozen bit position in D is introduced (where for example, values of frozen bit positions in C and values of bit positions in D are the same in one-to-one correspondence). During the encoding, a value of the non-frozen bit position in D (that is, a bit carried in the non-frozen bit position) may be determined based on the value of the frozen bit position in C (that is, a bit carried in the frozen bit position). During the decoding, the value of the frozen bit position in C may be determined based on a value of the non-frozen bit position in D. In this way, bit position indexes of the frozen bit position and the system bit position in the systematic polar code may overlap. The system bit position and the frozen bit position in the systematic polar code are decoupled. This brings larger encoding design space, so that encoding complexity is reduced, and encoding flexibility is improved.

In an example, when the joint source-channel coding is implemented based on a systematic polar code whose code length is 8, a mutual mapping relationship between a frozen bit position whose bit position index is 4 and a non-frozen bit position whose bit position index is 3 is introduced, bit position indexes of frozen bit positions may be 0, 1, 2, and 4, and bit position indexes of system bit positions may be 4, 5, 6, and 7. In a polar encoding process, a value of the non-frozen bit position whose bit position index is 3 may be determined based on a value of the frozen bit position whose bit position index is 4. An encoding problem in which a systematic polar code whose N is 8 corresponds to bit position indexes 0, 1, 2, 3, 4, 5, 6, and 7 may be split into two encoding sub-problems in which the systematic polar code is split to respectively correspond to the bit position indexes 0, 1, 2, and 3 and the bit position indexes 4, 5, 6, and 7. Parallel encoding may be performed on each encoding sub-problem. Encoding complexity is equivalent to that of performing one non-systematic polar code encoding process, so that the encoding complexity can be reduced. In addition, this is applicable to a plurality of system bit position setting manners, and encoding flexibility can be improved.

Optionally, that a frozen bit position in C and a non-frozen bit position in D are mapped to each other includes: the frozen bit position in C and the non-frozen bit position in D are mapped to each other based on a mapping matrix, where the mapping matrix is an $N_C$-dimensional full rank matrix or an $N_C$-dimensional unit matrix, and $N_C$ is equal to a quantity of frozen bit positions in C.

In a possible design, to ensure that the code length N can meet an encoding requirement, N is a smallest integer power of 2 that is greater than K+E or twice a smallest integer power of 2 that is greater than max(K, E).

In a possible design, the rate matching includes shortening (shortening) and/or puncturing (puncturing). The N second bit positions include S1 shortened bit positions and/or S2 punctured bit positions, S2 is equal to the larger of K-E and 0, and S1 is equal to N-K-E-S2.

In the foregoing design, for a scenario with a special prior distribution source, an encoding construction and rate matching manner is redesigned (where for example, puncturing processing is performed on the second bit position). This not only can retain the advantages of the systematic polar code, but also can adapt to different prior distributions of sources, so that transmission efficiency is improved.

In a possible design, A includes the last K second bit positions other than the S1 shortened bit positions and the S2 punctured bit positions in the N second bit positions; and/or B includes first bit positions that are in the N first bit positions and that correspond to the S1 shortened bit positions and the S2 punctured bit positions, and E first bit positions selected based on channel reliability or code reselection.

In the foregoing design, the last K second bit positions other than the shortened bit positions and the punctured bit positions in the N second bit positions are directly used as system bit positions, so that an encoding process can be simplified, and encoding efficiency can be improved.

In a possible design, the performing polar encoding on the information bit sequence, to determine an encoded bit sequence includes: determining a first intermediate encoded bit sequence based on the information bit sequence and a first polarization transformation submatrix, where the first polarization transformation submatrix is a polarization transformation submatrix corresponding to A in the polarization transformation matrix; determining a second intermediate encoded bit sequence based on the first intermediate encoded bit sequence, a mutual mapping relationship between the frozen bit position in C and the non-frozen bit position in D, and a bit position index intersection set of B and $M^A$, where a length of the second intermediate encoded bit sequence is equal to a quantity of second bit positions included in $M^A$; and determining the encoded bit sequence based on the second intermediate encoded bit sequence, a second polarization transformation submatrix, and the information bit sequence, where the second polarization transformation submatrix is a polarization transformation submatrix corresponding to $M^A$ in the polarization transformation matrix.

According to the foregoing method, an encoding problem in which a systematic polar code whose code length is N corresponds to bit position indexes 0, 1, ..., and N may be split into two encoding sub-problems. Parallel encoding is performed on each encoding sub-problem. Encoding complexity is equivalent to that of performing one non-systematic polar code encoding process, so that the encoding complexity can be reduced.

In a possible design, that a length of the information bit sequence is K includes: a sum of the length of the information bit sequence and a length of a cyclic redundancy check (cyclic redundancy check, CRC) bit sequence corresponding to information bits is K.

In the foregoing design, a CRC bit corresponding to the information bit is set, so that an error correction capability for decoding can be improved, decoding reliability can be improved, and an implementation is simple.

In a possible design, the first intermediate encoded bit sequence includes a third intermediate encoded bit sequence and the CRC bit sequence, the third intermediate encoded bit sequence is determined based on the information bit sequence and the first polarization transformation submatrix, and the CRC bit sequence is determined based on the third intermediate encoded bit sequence.

In the foregoing design, the CRC bit is set on a to-be-encoded side (that is, a non-codeword side) of the systematic polar code, and a check relationship is formed between the CRC bit and an encoded bit sequence on the to-be-encoded side. This facilitates early stop of decoding.

According to a second aspect, an embodiment of this application provides a decoding method. The method includes: obtaining a to-be-decoded symbol sequence, where a length of the to-be-decoded symbol sequence is E; and performing polar decoding on the to-be-decoded symbol sequence based on a code rate R or a length K of an information bit sequence and a log likelihood ratio LLR corresponding to a system bit position, to determine the information bit sequence, where a systematic polar code on which polar decoding is performed includes a polarization transformation matrix and N first bit positions and N second bit positions that correspond to the polarization transformation matrix; the N second bit positions include a system bit position set A and a non-system bit position set $M^A$, and the N first bit positions include a frozen bit position set B and a non-frozen bit position set $M^B$; there is a frozen bit position subset C in B, there is a non-frozen bit position subset D in $M^B$, and a frozen bit position in C and a non-frozen bit position in D are mapped to each other; C is determined based on a bit position index intersection set of B and A, and D is determined based on a bit position index intersection set of $M^B$ and $M^A$; and K is equal to ER.

The decoding method may be performed by a decoding device such as a network device or a terminal device, or may be performed by a component (such as a processor, a chip, or a chip system) of the decoding device, or may be implemented by a logical module or software that can implement all or some functions of the decoding device.

In addition, it should be understood that, for the systematic polar code, a system bit position may be for carrying an information bit sequence, and a total quantity of system bit positions and frozen bit positions is equal to a code length N of the systematic polar code. Therefore, in this embodiment of this application, A includes K system bit positions, B includes N-K frozen bit positions, $M^A$ includes N-K non-system bit positions, and $M^B$ includes K non-frozen bit positions.

Optionally, that a frozen bit position in C and a non-frozen bit position in D are mapped to each other includes: the frozen bit position in C and the non-frozen bit position in D are mapped to each other based on a mapping matrix, where the mapping matrix is an $N_C$-dimensional full rank matrix or an $N_C$-dimensional unit matrix, and $N_C$ is equal to a quantity of frozen bit positions in C.

In a possible design, to ensure that the code length N can meet an encoding requirement, N is a smallest integer power of 2 that is greater than K+E or twice a smallest integer power of 2 that is greater than max(K, E).

In a possible design, the N second bit positions include S1 shortened bit positions and/or S2 punctured bit positions, S2 is equal to the larger of K-E and 0, and S1 is equal to N-K-E-S2.

In a possible design, A includes the last K second bit positions other than the S1 shortened bit positions and the S2 punctured bit positions in the N second bit positions; and/or B includes first bit positions that are in the N first bit positions and that correspond to the S1 shortened bit positions and the S2 punctured bit positions, and E first bit positions selected based on channel reliability or code reselection.

In a possible design, the performing polar decoding on the to-be-decoded symbol sequence, to determine the information bit sequence includes: determining a first intermediate decoded bit sequence based on the to-be-decoded symbol sequence, the LLR corresponding to the system bit position, the polarization transformation matrix, a mutual mapping relationship between the frozen bit position in C and the non-frozen bit position in D, and a bit position index intersection set of B and $M^A$; and determining the information bit sequence based on the first intermediate decoded bit sequence and the polarization transformation matrix.

In a possible design, that the length of the information bit sequence is K includes: a sum of the length of the information bit sequence and a length of a CRC bit sequence corresponding to the information bit sequence is K.

In a possible design, the first intermediate decoded bit sequence includes a second intermediate decoded bit sequence and the CRC bit sequence, and the CRC bit sequence is for checking the second intermediate decoded bit sequence, where a bit position index of the second intermediate decoded bit sequence corresponds to a bit position index of the information bit sequence in A, and a bit position index of the CRC bit sequence corresponds to a bit position index other than the bit position index of the information bit sequence in A.

According to a third aspect, an embodiment of this application provides a communication apparatus. The communication apparatus may include: an input/output unit, configured to obtain an information bit sequence, where a length of the information bit sequence is K; and a processing unit, configured to perform polar encoding on the information bit sequence based on a target code length E or a code rate R, to determine an encoded bit sequence, where a systematic polar code on which polar encoding is performed includes a polarization transformation matrix and N first bit positions and N second bit positions that correspond to the polarization transformation matrix; the N second bit positions include a system bit position set A and a non-system bit position set $M^A$, and the N first bit positions include a frozen bit position set B and a non-frozen bit position set $M^B$; there is a frozen bit position subset C in B, there is a non-frozen bit position subset D in $M^B$, and a frozen bit position in C and a non-frozen bit position in D are mapped to each other; C is determined based on a bit position index intersection set of B and A, and D is determined based on a bit position index intersection set of $M^B$ and $M^A$; and A includes K system bit positions, B includes N-K frozen bit positions, a length of the encoded bit sequence is N, and R is equal to K/E. The processing unit is further configured to perform rate matching on the encoded bit sequence to obtain a target encoded bit sequence, where a length of the target encoded bit sequence is E, and a set of bit positions in the target encoded bit sequence is a subset of $M^A$.

Optionally, that a frozen bit position in C and a non-frozen bit position in D are mapped to each other includes that the frozen bit position in C and the non-frozen bit position in D are mapped to each other based on a mapping matrix, where the mapping matrix is an $N_C$-dimensional full rank matrix or an $N_C$-dimensional unit matrix, and $N_C$ is equal to a quantity of frozen bit positions in C.

In a possible design, to ensure that the code length N can meet an encoding requirement, N is a smallest integer power of 2 that is greater than K+E or twice a smallest integer power of 2 that is greater than max(K, E).

In a possible design, the rate matching includes shortening and/or puncturing. Optionally, the N second bit positions include S1 shortened bit positions and/or S2 punctured bit positions, S2 is equal to the larger of K-E and 0, and S1 is equal to N-K-E-S2.

In a possible design, A includes the last K second bit positions other than the S1 shortened bit positions and the S2 punctured bit positions in the N second bit positions; and/or B includes first bit positions that are in the N first bit positions and that correspond to the S1 shortened bit positions and the S2 punctured bit positions, and E first bit positions selected based on channel reliability or code reselection.

In a possible design, when performing polar encoding on the information bit sequence, to determine the encoded bit sequence, the processing unit is specifically configured to: determine a first intermediate encoded bit sequence based on the information bit sequence and a first polarization transformation submatrix, where the first polarization transformation submatrix is a polarization transformation submatrix corresponding to A in the polarization transformation matrix; determine a second intermediate encoded bit sequence based on the first intermediate encoded bit sequence, a mutual mapping relationship between the frozen bit position in C and the non-frozen bit position in D, and a bit position index intersection set of B and $M^A$, where a length of the second intermediate encoded bit sequence is equal to a quantity of second bit positions included in $M^A$; and determine the encoded bit sequence based on the second intermediate encoded bit sequence, a second polarization transformation submatrix, and the information bit sequence, where the second polarization transformation submatrix is a polarization transformation submatrix corresponding to $M^A$ in the polarization transformation matrix.

In a possible design, that a length of the information bit sequence is K includes: a sum of the length of the information bit sequence and a length of a CRC bit sequence corresponding to information bits is K.

In a possible design, the first intermediate encoded bit sequence includes a third intermediate encoded bit sequence and the CRC bit sequence, the third intermediate encoded bit sequence is determined based on the information bit sequence and the first polarization transformation submatrix, and the CRC bit sequence is determined based on the third intermediate encoded bit sequence.

According to a fourth aspect, an embodiment of this application provides a communication apparatus. The communication apparatus may include an input/output unit and a processing unit. The input/output unit is configured to obtain a to-be-decoded symbol sequence, where a length of the to-be-decoded symbol sequence is E. The processing unit is configured to perform polar decoding on the to-be-decoded symbol sequence based on a code rate R or a length K of an information bit sequence and a log likelihood ratio LLR corresponding to a system bit position, to determine the information bit sequence, where a systematic polar code on which polar decoding is performed includes a polarization transformation matrix and N first bit positions and N second bit positions that correspond to the polarization transformation matrix; the N second bit positions include a system bit position set A and a non-system bit position set $M^A$, and the N first bit positions include a frozen bit position set B and a non-frozen bit position set $M^B$; there is a frozen bit position subset C in B, there is a non-frozen bit position subset D in $M^B$, and a frozen bit position in C and a non-frozen bit position in D are mapped to each other; C is determined based on a bit position index intersection set of B and A, and D is determined based on a bit position index intersection set of $M^B$ and $M^A$; and A includes K system bit positions, B includes N-K frozen bit positions, and K is equal to ER.

Optionally, that a frozen bit position in C and a non-frozen bit position in D are mapped to each other includes that the frozen bit position in C and the non-frozen bit position in D are mapped to each other based on a mapping matrix, where the mapping matrix is an $N_C$-dimensional full rank matrix or an $N_C$-dimensional unit matrix, and $N_C$ is equal to a quantity of frozen bit positions in C.

In a possible design, to ensure that the code length N can meet an encoding requirement, N is a smallest integer power of 2 that is greater than K+E or twice a smallest integer power of 2 that is greater than max(K, E).

In a possible design, the N second bit positions include S1 shortened bit positions and/or S2 punctured bit positions, S2 is equal to the larger of K-E and 0, and S1 is equal to N-K-E-S2.

In a possible design, A includes the last K second bit positions other than the S1 shortened bit positions and the S2 punctured bit positions in the N second bit positions; and/or B includes first bit positions that are in the N first bit positions and that correspond to the S1 shortened bit positions and the S2 punctured bit positions, and E first bit positions selected based on channel reliability or code reselection.

In a possible design, when performing polar decoding on the to-be-decoded symbol sequence, to determine the information bit sequence, the processing unit is specifically configured to: determine a first intermediate decoded bit sequence based on the to-be-decoded symbol sequence, the LLR corresponding to the system bit position, the polarization transformation matrix, a mutual mapping relationship between the frozen bit position in C and the non-frozen bit position in D, and a bit position index intersection set of B and $M^A$; and determine the information bit sequence based on the first intermediate decoded bit sequence and the polarization transformation matrix.

In a possible design, that the length of the information bit sequence is K includes: a sum of the length of the information bit sequence and a length of a CRC bit sequence corresponding to the information bit sequence is K.

In a possible design, the first intermediate decoded bit sequence includes a second intermediate decoded bit sequence and the CRC bit sequence, and the CRC bit sequence is for checking the second intermediate decoded bit sequence, where a bit position index of the second intermediate decoded bit sequence corresponds to a bit position index of the information bit sequence in A, and a bit position index of the CRC bit sequence corresponds to a bit position index other than the bit position index of the information bit sequence in A.

According to a fifth aspect, an embodiment of this application provides a communication apparatus. The communication apparatus includes an interface circuit and a processor, and the processor and the interface circuit are coupled to each other. The processor is configured to implement the method according to any one of the first aspect or the possible designs of the first aspect by using a logic circuit or by executing code instructions. The interface circuit is configured to: receive a signal from a communication apparatus other than the communication apparatus and transmit the signal to the processor, or send a signal from the processor to a communication apparatus other than the communication apparatus. It may be understood that the interface circuit may be a transceiver, a transceiver machine, a transceiver, or an input/output interface.

Optionally, the communication apparatus may further include a memory, configured to: store instructions executed by the processor, or store input data required for running instructions by the processor, or store data generated after the processor runs instructions. The memory may be a physically independent unit, or may be coupled to the processor, or the processor includes the memory.

According to a sixth aspect, an embodiment of this application provides a communication apparatus. The communication apparatus includes an interface circuit and a processor, and the processor and the interface circuit are coupled to each other. The processor is configured to implement the method according to any one of the second aspect or the possible designs of the second aspect by using a logic circuit or by executing code instructions. The interface circuit is configured to: receive a signal from a communication apparatus other than the communication apparatus and transmit the signal to the processor, or send a signal from the processor to a communication apparatus other than the communication apparatus. It may be understood that the interface circuit may be a transceiver, a transceiver machine, a transceiver, or an input/output interface.

Optionally, the communication apparatus may further include a memory, configured to: store instructions executed by the processor, or store input data required for running instructions by the processor, or store data generated after the processor runs instructions. The memory may be a physically independent unit, or may be coupled to the processor, or the processor includes the memory.

According to a seventh aspect, an embodiment of this application provides a communication system. The communication system includes an encoding device and a decoding device. The encoding device may implement the method according to any one of the first aspect or the possible designs of the first aspect, and the decoding device may implement the method according to any one of the second aspect or the possible designs of the second aspect.

According to an eighth aspect, an embodiment of this application provides a computer-readable storage medium. The storage medium stores a computer program or instructions. When the computer program or the instructions are executed, the method according to any one of the first aspect or the possible designs of the first aspect, or the method according to any one of the second aspect or the possible designs of the second aspect may be implemented.

According to a ninth aspect, an embodiment of this application further provides a computer program product, including a computer program or instructions. When the computer program or the instructions are executed, the method according to any one of the first aspect or the possible designs of the first aspect, or the method according to any one of the second aspect or the possible designs of the second aspect may be implemented.

According to a tenth aspect, an embodiment of this application further provides a chip. The chip is coupled to a memory, and is configured to read and execute a program or instructions stored in the memory, to implement the method according to any one of the first aspect or the possible designs of the first aspect, or implement the method according to any one of the second aspect or the possible designs of the second aspect.

For technical effects that can be achieved in the second aspect to the tenth aspect, refer to technical effects that can be achieved in the first aspect. Details are not described herein again.

**BRIEF DESCRIPTION OF DRAWINGS**

FIG. 1 is a diagram of an architecture of a communication system according to an embodiment of this application;
FIG. 2 is a diagram of an encoding and decoding procedure according to an embodiment of this application;
FIG. 3 is a diagram of an encoding process according to an embodiment of this application;
FIG. 4 is a diagram of a decoding path in an SCL algorithm according to an embodiment of this application;
FIG. 5 is a diagram 1 of a systematic polar code according to an embodiment of this application;
FIG. 6 is a diagram of parallel encoding of a systematic polar code according to an embodiment of this application;
FIG. 7 is a diagram of an encoding and decoding method according to an embodiment of this application;
FIG. 8 is a diagram 2 of a systematic polar code according to an embodiment of this application;
FIG. 9 is a diagram 1 of a polar encoding process according to an embodiment of this application;
FIG. 10 is a diagram 2 of a polar encoding process according to an embodiment of this application;
FIG. 11 is a diagram of a pre-transformed systematic polar code according to an embodiment of this application;
FIG. 12 is a diagram of a precoding matrix according to an embodiment of this application;
FIG. 13 is a diagram 3 of a polar encoding process according to an embodiment of this application;
FIG. 14 is a diagram of a polar decoding process according to an embodiment of this application;
FIG. 15 is a diagram 1 of carrying a check bit in a systematic polar code according to an embodiment of this application;
FIG. 16 is a diagram 2 of carrying a check bit in a systematic polar code according to an embodiment of this application;
FIG. 17 is a diagram 3 of carrying a check bit in a systematic polar code according to an embodiment of this application;
FIG. 18 is a diagram 1 of a communication apparatus according to an embodiment of this application; and
FIG. 19 is a diagram 2 of a communication apparatus according to an embodiment of this application.

**DESCRIPTION OF EMBODIMENTS**

The technical solutions in embodiments of this application may be applied to various communication systems, for example, a global system for mobile communications (global system for mobile communications, GSM), an enhanced data rate for GSM evolution (enhanced data rate for GSM evolution, EDGE) system, a wideband code division multiple access (wideband code division multiple access, WCDMA) system, a time division-synchronization code division multiple access (time division-synchronization code division multiple access, TD-SCDMA) system, a long term evolution (long term evolution, LTE) system, a worldwide interoperability for microwave access (worldwide interoperability for microwave access, WiMAX) communication system, and a 5th generation (5th generation, 5G) mobile communication system, for example, a new radio (new radio, NR) system. The technical solutions provided in this application may be further applied to a future communication system, for example, a 6th generation mobile communication system. Alternatively, the communication system may be a Bluetooth (Bluetooth) communication system, a wireless local area network (wireless local area network, WLAN)/wireless communication technology (Wi-Fi) communication system, a narrowband internet of things (narrowband internet of things, NB-IoT) communication system, or the like.

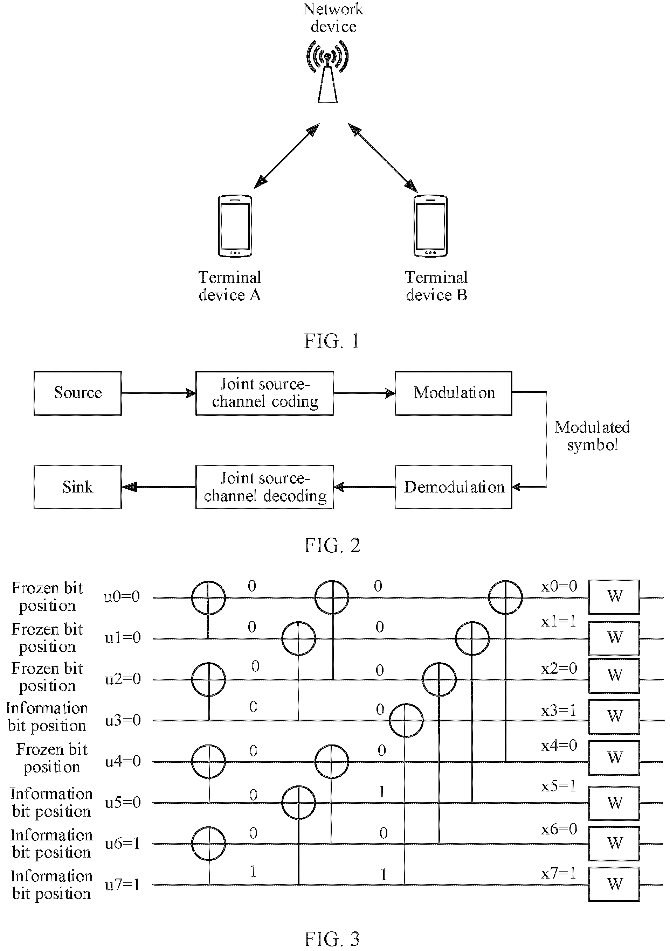

FIG. 1 is a diagram of an architecture of a communication system to which an embodiment of this application is applied. As shown in FIG. 1, the communication system includes a network device and a terminal device. For example, there is one network device, and there are two terminal devices (a terminal device A and a terminal device B). When the network device is a transmitter, the terminal device A or the terminal device B is a receiver; and when the terminal device A or the terminal device B is a transmitter, the network device is a receiver.

The terminal device may also be referred to as a terminal, user equipment (user equipment, UE), a mobile station, a mobile terminal, or the like. The terminal device may be widely used in various scenarios such as device-to-device (device-to-device, D2D), vehicle-to-everything (vehicle-to-everything, V2X) communication, machine type communication (machine type communication, MTC), an internet of things (internet of things, IoT), virtual reality, augmented reality, industrial control, self-driving, telemedicine, a smart grid, smart furniture, a smart office, a smart wearable, smart transportation, and a smart city. The terminal device may be a mobile phone, a tablet computer, a computer having a wireless transceiver function, a wearable device, a vehicle, an uncrewed aerial vehicle, a helicopter, an airplane, a ship, a robot, a robotic arm, a smart home device, a vehicle-mounted terminal, an IoT terminal, a wearable device, or the like. A specific technology and a specific device form used by the terminal device are not limited in embodiments of this application.

The network device may also be referred to as an access network (access network, AN) device or a radio access network (radio access network, RAN) device, and may be a base station (base station), an evolved NodeB (evolved NodeB, eNodeB), a transmission reception point (transmission reception point, TRP), an integrated access and backhaul (integrated access and backhaul, IAB) node, a next generation NodeB (next generation NodeB, gNB) in a 5th generation (5th generation, 5G) mobile communication system, a base station in a 6th generation (6th generation, 6G) mobile communication system, a base station in another future mobile communication system, an access node in a Wi-Fi system, a home base station (for example, a home evolved NodeB, or a home NodeB, HNB), an access point (access point, AP) in a wireless fidelity (wireless fidelity, Wi-Fi) system, a wireless relay node, a wireless backhaul node, and the like, or may be a module or unit that completes some functions of a base station, for example, may be a central unit (central unit, CU), or may be a distributed unit (distributed unit, DU). The CU herein completes functions of a radio resource control protocol and a packet data convergence protocol (packet data convergence protocol, PDCP) of the base station, and may further complete a function of a service data adaptation protocol (service data adaptation protocol, SDAP). The DU completes functions of a radio link control layer and a medium access control (medium access control, MAC) layer of the base station, and may further complete some or all of functions of a physical layer. For specific descriptions of the foregoing protocol layers, refer to technical specifications related to the 3rd generation partnership project (3rd generation partnership project, 3GPP). The network device may alternatively be a non-terrestrial (non-terrestrial) base station, for example, a low earth orbit (low earth orbit, LEO)/very low earth orbit (very low earth orbit, VLEO) satellite or a high-altitude platform station (high-altitude platform station, HAPS), or may be a terminal that is responsible for a function of the network device in V2X, D2D, and machine-to-machine (machine-to-machine, M2M) communication.

In embodiments of this application, the function of the network device may alternatively be performed by a module (for example, a chip) in the network device, or may be performed by a control subsystem including the function of the network device. The control subsystem including the function of the network device may be a control center in the foregoing application scenarios such as a smart grid, industrial control, smart transportation, and a smart city. A function of the terminal device may alternatively be performed by a module (for example, a chip or a modem) in the terminal device, or may be performed by an apparatus including the function of the terminal device.

The communication system shown in FIG. 1 is still used as an example. To ensure reliability of communication between devices, encoding and decoding processing may be performed on information. For processing, refer to an encoding and decoding procedure shown in FIG. 2. Joint source-channel coding and modulation are sequentially performed on a source of the transmitter, and then a modulated symbol is output. After receiving the modulated symbol, a receiver sequentially performs demodulation and joint source-channel decoding to obtain a sink, and the receiver may obtain useful information based on the sink.

For ease of understanding by a person skilled in the art, the following explains and describes some terms in embodiments of this application.

(1) Upper triangular matrix: A square matrix whose elements below a main diagonal are all 0 is referred to as an upper triangular matrix. The upper triangular matrix has properties such as a determinant being obtained through multiplication of diagonal elements, an upper triangular matrix being also an upper triangular matrix after being multiplied by a coefficient, and a result obtained through an addition or subtraction operation and a multiplication operation between upper triangular matrices being still an upper triangular matrix.

(2) Polar code encoding: A polar code is a linear block code, a polarization transformation matrix is $G_N$, the polarization transformation matrix may also be denoted as G, and the polarization transformation matrix may also be referred to as a coding matrix or a generator matrix. An encoding process is $x_1^N = u_1^N G_N$, where $u_1^N = (u1, u2, \ldots, uN)$ is a binary row vector, that is, a binary sequence, a length is $N$, $N$ is a polar code length, $G_N$ is an $N \times N$ matrix, and

$$G_N = F_2^{\otimes(\log_2(N))}.$$

$F_2^{\otimes(\log_2(N))}$ is defined as a Kronecker (Kronecker) product of $\log_2 N$ matrices $F_2$, where

$$F_2 = \begin{bmatrix} 1 & 0 \\ 1 & 1 \end{bmatrix}.$$

In a polar code encoding process, some of bits in $u_1^N$ are for carrying information, the bits carrying the information are referred to as information bits, the some of the bits for carrying the information form an information bit set, and a set of bit position indexes of these bits is denoted as $\mathcal{A}$; the other bits are set to fixed values pre-agreed by a receiver and a transmitter, and are referred to as a set of fixed bits or frozen bits (frozen bits), and a set of bit position indexes of these bits is represented by a complementary set $\mathcal{A}^c$ of $\mathcal{A}$. The polar code encoding process is equivalent to

$$\mathrm{x}_1^N = \mathrm{u}_A \mathrm{G}_N.(A) \oplus \mathrm{u}_{A^c} \mathrm{G}_N.(A^C)$$

. Herein, $G_N(A)$ is a submatrix obtained from rows corresponding to the bit position indexes in the set A in $G_N$, $G_N(A^C)$ is a submatrix obtained from rows corresponding to bit position indexes in the set $\mathcal{A}^c$ in $G_N$, $u_{\mathcal{A}}$ is an information bit set in $u_1^N$, where a quantity of bits is K, and $u_{Ac}$ is a set of frozen bits in $u_1^N$, where a quantity of bits is N-K, and the bits are known bits. These frozen bits are usually set to 0. However, the frozen bits may be randomly set provided that the receiver and the transmitter pre-agree on the setting. Therefore, encoding output of the polar code may be simplified as:

$$x_1^N = u_{\mathcal{A}} G_N(\mathcal{A}).$$

Herein, $u_{\mathcal{A}}$ is an information bit set in $u_1^N$, $u_{\mathcal{A}}$ is a row vector whose length is *K*, that is, $|\mathcal{A}| = K$, $|\cdot|$ represents a quantity of elements in the set, *K* is an information block size, or *K* is a quantity of information bits, or K is a size of the information bit set, $G_N(\mathcal{A})$ is a submatrix obtained from rows corresponding to the bit position indexes in the set $\mathcal{A}$ in the matrix $G_N$, and $G_N(\mathcal{A})$ is a $K \times N$ matrix.

A process of constructing the polar code is a process of selecting the set $\mathcal{A}$. This determines performance of the polar code. The process of constructing the polar code is usually as follows: determining, based on a code length N, that there are N polarized channels in total, where the N polarized channels respectively correspond to N rows of a polarization transformation matrix; calculating channel reliability of the polarized channels; and using bit position indexes of the first K polarized channels with higher channel reliability as elements of the set A, and using bit position indexes corresponding to remaining N-K polarized channels as elements of the bit position index set $\mathcal{A}^c$ of the frozen bit. The set $\mathcal{A}$ determines a position of the information bit, and the set $\mathcal{A}^c$ determines a position of the frozen bit.

FIG. 3 shows an 8×8 polarization transformation matrix. FIG. 3 shows an example of a specific encoding process. The left side may be understood as a to-be-encoded side, and a bit position on the left side is represented by u; and the right side may be understood as an encoding side (or a codeword side), and a bit position on the right side is represented by x. The process from left to right is a process in which a transmitter encodes a to-be-encoded bit sequence. To-be-encoded information bits are represented by a sequence u (0, 0, 0, 0, 0, 0, 1, 1), and after being processed by using the polarization transformation matrix, encoded bits are represented by a sequence x (0, 1, 0, 1, 0, 1, 0, 1). If x is mapped to a modulated symbol, x may be transmitted on a channel W. A bit position corresponding to high channel reliability is for mapping the information bit, and a bit position corresponding to low channel reliability is for mapping a frozen bit. As shown in FIG. 3, {u0, u1, u2, u4} are frozen bit positions, that is, positions of the frozen bits, and {u3, u5, u6, u7} are information bit positions, that is, positions of the information bits.

Further descriptions are provided with reference to FIG. 3. In the encoding process, two adjacent columns are an encoding layer, a left column of bits is input bits of the encoding layer, and a right column of bits is output bits of the encoding layer. For example, in a leftmost encoding layer, an input bit sequence is (0, 0, 0, 0, 0, 0, 1, 1), and an output bit sequence is (0, 0, 0, 0, 0, 0, 0, 1). An operation symbol " $\oplus$ " in the middle of the encoding layer represents an exclusive OR operation, " $\oplus$ " represents an exclusive OR operation between a bit in a row in which " $\oplus$ " is located and a bit in a row reached by " $\oplus$ ", and a bit to the right of " $\oplus$ " is an operation result. For example, in the leftmost encoding layer, a " $\oplus$ " operation is performed on a first input bit (with a value of 0) and a second input bit (with a value of 0) to obtain a first output bit (with a value of 0).

(3) Polar code decoding: A successive cancellation (successive cancellation, SC) decoding method is an effective decoding algorithm of a polar code. After obtaining a to-be-decoded symbol sequence, a decoding device calculates log likelihood ratios (log likelihood ratios, LLRs) of information bits one by one based on the to-be-decoded symbol sequence. If an LLR of an information bit is greater than 0, a decoding result is 0; or if an LLR of an information bit is less than 0, a decoding result is 1; and a decoding result of a frozen bit is set to 0 regardless of a value of the LLR.

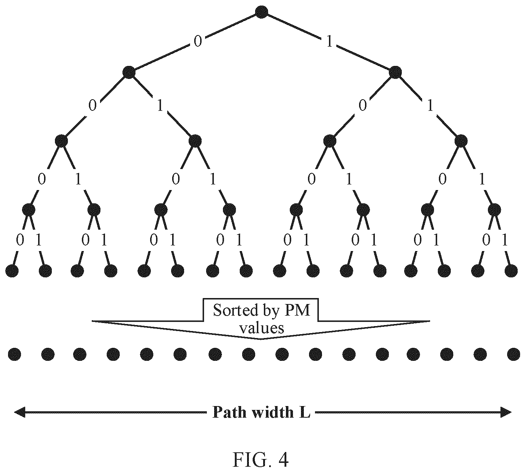

Performance of the SC decoding method is poor. A result of a previous decoded bit is used as input for calculation of a next decoded bit. Once an error occurs, error spreading is caused, and there is no opportunity to recover the error. Therefore, decoding performance is not high. To resolve this problem, in a successive cancellation list (successive cancellation list, SCL) algorithm, when each information bit is decoded in the SCL algorithm, decoding results corresponding to 0 and 1 are both stored as two branch decoding paths (referred to as path splitting for short). FIG. 4 is a diagram of a decoding path in an SCL algorithm. As shown in FIG. 4, each layer represents one decoded bit. If a decoding result is 0, a path is developed along a left subtree; or if a decoding result is 1, a path is developed along a right subtree. When a total quantity of decoding paths exceeds a preset path width L (where usually, L is an integer power of 2), L paths with optimal path metric (path metric, PM) values are selected and stored, and a path continues to be developed to obtain through decoding a subsequent decoded bit. A PM value is for determining quality of the path, and the PM value is obtained through LLR calculation. For a decoded bit at each level, the PM values of the L paths are sorted in ascending order, and a correct path is selected by using the PM values. This process is repeated until a last bit is decoded.

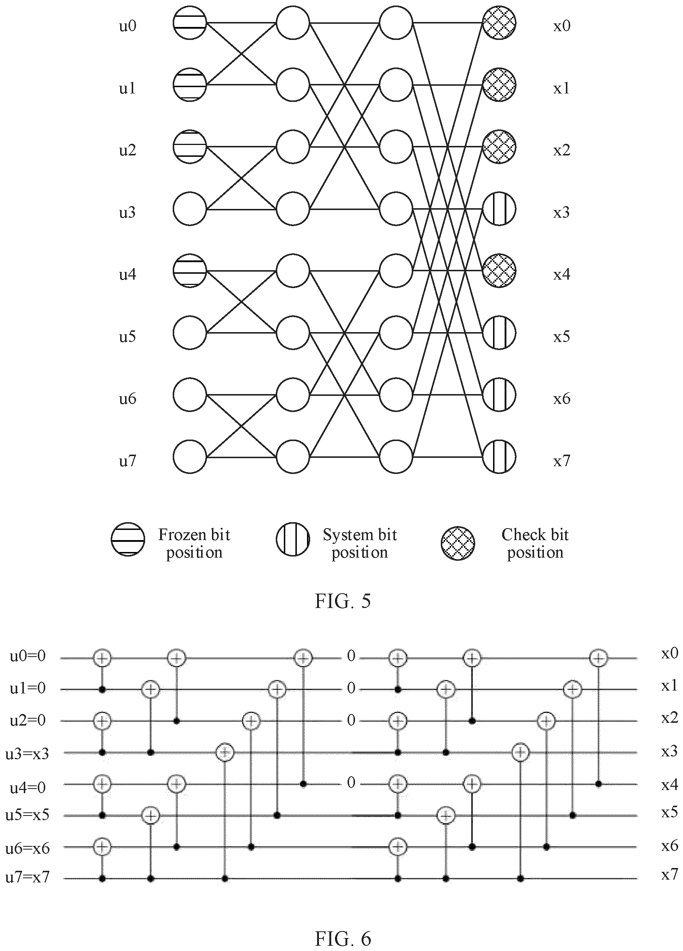

(4) Systematic polar code: The systematic polar code is a special polar code, and is a polar code in which an information bit is directly carried on an encoding side (a codeword side). In comparison with a non-systematic polar code, the systematic polar code has advantages such as better BER performance, more convenient concatenation with another code, and wide application (where for example, joint source-channel coding can be performed). FIG. 5 is a diagram of an 8×8 systematic polar code. u0, u1, u2, and u4 on a to-be-encoded side are frozen bit positions and may be for carrying frozen bits. x3, x5, x6, and x7 on an encoding side are system bit positions that actually carry information bits, and a function of a system bit position is similar to a function of an information bit position in a non-systematic polar code. A systematic polar code encoding process may be understood as a process of determining, based on a frozen bit carried in a frozen bit position and an information bit actually carried in a system bit position, check bits carried in check bit positions (x0, x1, x2, and x4). A combination of the check bit and the information bit actually carried in the system bit position is output as an encoded bit sequence.

Because a position relationship between the system bit position and the frozen bit position in the systematic polar code is mutual coupling, a current scheme for encoding the systematic polar code is a serial encoding scheme. In the serial encoding solution, $N\log_2 N$ encoding problems of the systematic polar code are continuously decomposed, and are decomposed into $N\log_2 N$ encoding sub-problems. The $N\log_2 N$ encoding sub-problems are serially executed to complete the encoding process, and algorithm complexity is $N\log_2 N$. However, because serial execution is required for the encoding process, a large encoding delay is caused. In addition, a common scenario to which the serial encoding scheme is applied is an encoding process for a biased source (that is, an information bit sequence with an uneven distribution of 0s/1s). This requirement requires that the biased source is encoded as an information bit, and then an obtained check bit is output. However, it is very difficult to find an optimal code construction in an existing serial encoding framework. Specifically, all possible information bit placement manners need to be traversed, respective error rates are calculated, and then an optimal information bit placement manner is selected from all the possible information bit placement manners. This has high complexity.

Another scheme for encoding the systematic polar code is a parallel encoding method. As shown in FIG. 6, to carry information bits on x3, x5, x6, and x7 on an encoding side, in an encoding process, information bits are first actually carried on u3, u5, u6, and u7 on a corresponding to-be-encoded side, and one non-systematic polar code encoding process is first performed. Further, a bit corresponding to a frozen bit position in an obtained sequence is forcibly set to 0, the non-systematic polar code encoding process is performed on the sequence again, and then an obtained result is output. That is, the encoding process is completed. It can be learned that in this method, encoding with high parallelism of the non-systematic polar code is retained. However, because two non-systematic polar code encoding processes need to be completed, calculation complexity is $2N\log_2 N$, and is twice that of the non-systematic polar code encoding process.

It can be learned from the foregoing encoding schemes of the systematic polar code that, because the position relationship between the system bit position and the frozen bit position in the systematic polar code is mutual coupling, the encoding process needs to be serially performed, or the non-systematic polar code encoding process needs to be performed in parallel for a plurality of times. This has problems of high encoding complexity and insufficient flexibility. Based on this, this application provides an encoding method, a decoding method, and an apparatus. Bit position mapping is introduced, so that bit position indexes of a frozen bit position and a system bit position (a bit position that actually carries an information bit) in a systematic polar code may overlap. The system bit position and the frozen bit position in the systematic polar code are decoupled, to bring larger encoding design space, reduce encoding complexity, and improve encoding flexibility. In addition, for a scenario in which joint source-channel coding has a special prior distribution source, values of some or all of non-system bit positions on a codeword side of the systematic polar code may be used as output. This not only retains advantages of the systematic polar code, but also can adapt to different prior distributions of sources and support the joint source-channel coding, so that transmission efficiency is improved. The following describes in detail embodiments of this application with reference to the accompanying drawings.

In addition, it should be understood that ordinal numbers such as "first" and "second" mentioned in embodiments of this application are used to distinguish between a plurality of objects, and are not used to limit sizes, content, a sequence, a time sequence, priorities, importance degrees, or the like of the plurality of obj ects. For example, a first threshold and a second threshold may be a same threshold, or may be different thresholds. In addition, this type of name does not indicate that values, corresponding parameters, priorities, importance degrees, or the like of the two thresholds are different.

In embodiments of this application, unless otherwise specified, a quantity of nouns represents "a singular noun or plural nouns", that is, "one or more". "At least one" means one or more, and "a plurality of" means two or more. "And/or" describes an association relationship between associated objects and indicates that three relationships may exist. For example, A and/or B may indicate the following three cases: Only A exists, both A and B exist, and only B exists, where A and B may be singular or plural. The character "/" generally indicates an "or" relationship between the associated objects. For example, A/B indicates A or B. "At least one of the following items (pieces)" or a similar expression thereof indicates any combination of these items, including a single item (piece) or any combination of a plurality of items (pieces). For example, at least one item (piece) of a, b, or c represents: a, b, c, a and b, a and c, b and c, or a, b, and c. Herein, a, b, and c may be singular or plural.

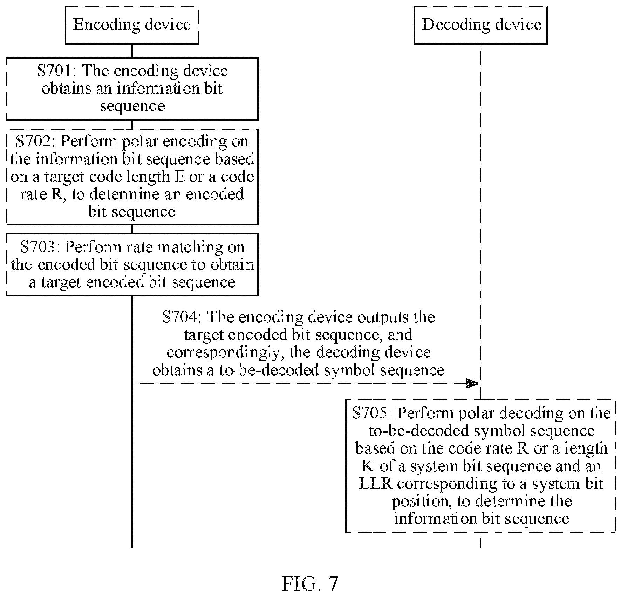

FIG. 7 is a diagram of an encoding and decoding method according to an embodiment of this application. In FIG. 7, for example, an encoding device and a decoding device are used as execution bodies to illustrate the method. For example, the encoding device may be a network device, and the decoding device may be a terminal device; or the encoding device is a terminal device, and the decoding device is a network device. This application does not limit an entity for executing the method. For example, the encoding device in FIG. 7 may alternatively be a chip, a chip system, or a processor that can support the encoding device to implement the method, or may be a logical module or software that can implement all or some of functions of the encoding device. Alternatively, the decoding device in FIG. 7 may be a chip, a chip system, or a processor that supports the decoding device to implement the method, or may be a logical module or software that can implement all or some of functions of the decoding device. The method includes the following steps.

S701: The encoding device obtains an information bit sequence, where a length of the information bit sequence is K.

S702: The encoding device performs polar encoding on the information bit sequence based on a target code length E or a code rate R, to determine an encoded bit sequence.

A systematic polar code on which polar encoding is performed includes a polarization transformation matrix and N first bit positions and N second bit positions that correspond to the polarization transformation matrix; the N second bit positions include a system bit position set A and a non-system bit position set $M^A$, and the N first bit positions include a frozen bit position set B and a non-frozen bit position set $M^B$; there is a frozen bit position subset C in B, there is a non-frozen bit position subset D in $M^B$, and a frozen bit position in C and a non-frozen bit position in D are mapped to each other; C is determined based on a bit position index intersection set of B and A, and D is determined based on a bit position index intersection set of $M^B$ and $M^A$; and a length of the encoded bit sequence is N, and R is equal to K/E.

For the systematic polar code, system bit positions may be for carrying the information bit sequence, and a total quantity of system bit positions and frozen bit positions is equal to a code length N of the systematic polar code. Therefore, in this embodiment of this application, A includes K system bit positions, and B includes N-K frozen bit positions. In other words, $M^A$ includes N-K non-system bit positions, and $M^B$ includes K non-frozen bit positions. In addition, it should be understood that the non-frozen bit position in the systematic polar code may also be referred to as an information bit position, but the information bit position (the non-frozen bit position) in the systematic polar code is not for actually carrying the information bit sequence; instead, the system bit position in the systematic polar code carries the information bit sequence. In other words, a function of the system bit position in the systematic polar code is equivalent to a function of the information bit position in a non-systematic polar code.

In a possible implementation, to ensure that the code length N meets an encoding requirement, N is a smallest integer power of 2 that is greater than K+E or twice a smallest integer power of 2 that is greater than max(K, E).

For the systematic polar code whose code length is N, two sides of the polarization transformation matrix of the systematic polar code respectively correspond to N bit positions, including the N first bit positions on a left side (that is, a to-be-encoded side) of the polarization transformation matrix and the N second bit positions on a right side (that is, an encoding side or a codeword side) of the polarization transformation matrix, and the N first bit positions may correspond to the N second bit positions based on the polarization transformation matrix. For example, bits carried in the N first bit positions and bits carried in the N second bit positions may be converted by using the polarization transformation matrix.

For the systematic polar code, the N second bit positions include the K system bit positions corresponding to the information bit sequence and E check bit positions corresponding to a target encoded bit sequence (or the target code length E). In other words, when K+E is not equal to N, rate matching needs to be performed. For example, shortening (shortening) and/or puncturing (puncturing) processing are/is performed on the N second bit positions. In this case, a quantity of second bit positions on which shortening and/or puncturing processing are/is performed in the N second bit positions is N-K-E, and is equal to a sum of a quantity S1 of shortened bit positions and a quantity S2 of punctured bit positions.

In a possible implementation, values of S1 and S2 may be determined based on the length K of the information bit sequence that is input through encoding and the target code length E that is output through encoding.

In an example, S2 may be set to be equal to the larger of K-E and 0, and S1 may be set to be equal to a difference between N-K-E and S2. To be specific, when K is greater than E, and the length of the information bit sequence that is input through encoding is greater than the output target code length, K-E punctured bit positions may be set. When K is less than or equal to E, and the length of the information bit sequence that is input through encoding is less than or equal to the output target code length, zero punctured bit positions may be set. In addition, a quantity of shortened bit positions that need to be set may be determined based on a quantity of punctured bit positions that are set and a value of N-K-E.

The S1 shortened bit positions and the S2 punctures may be randomly set, or may be set according to a specific rule. In an example, when neither E nor K is greater than N/2, the N second bit positions may be divided into the first N/2 second bit positions and the last N/2 second bit positions, the first S2 bit positions in the first N/2 second bit positions are set as punctured bit positions, bit positions other than the first S2+E bit positions in the first N/2 second bit positions are used as shortened bit positions, and the last N/2-K bit positions in the last N/2 second bit positions are used as shortened bit positions, where a quantity of shortened bit positions is N/2-K+N/2-S2-E, that is, there are a total of N-K-E-S2 shortened bit positions, and the quantity is equal to S1.

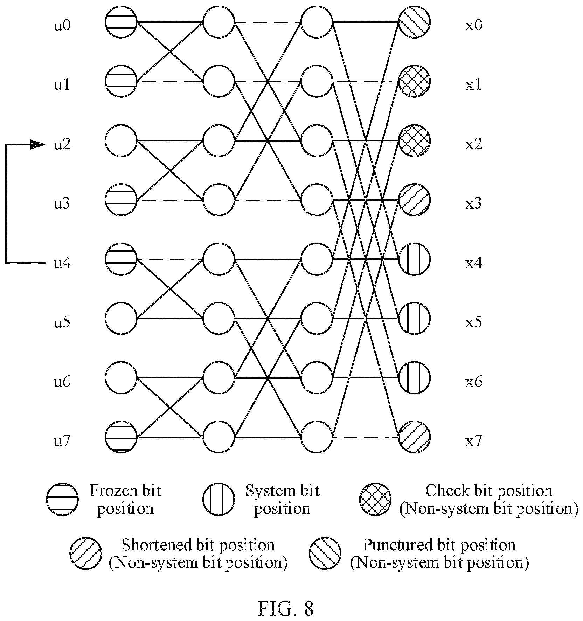

For example, N=8, E=2, and K=3, so that S2=K-E=1, and S1=N-K-E-S2=2. As shown in FIG. 8, a first (S2=1) bit position (x0) in the first N/2 second bit positions (x0 to x3) may be determined as a punctured bit position, and a last (N/2-S2-E=1) bit position (x3) is determined as a shortened bit position. A last (N/2-K=1) bit position (x7) in the last N/2 second bit positions (x4 to x7) may be determined as a shortened bit position.

In a possible implementation, for the system bit position in A, the last K second bit positions other than the S1 shortened bit positions and the S2 punctured bit positions in the N second bit positions may be determined as system bit positions, where K is equal to the length of the information bit sequence. In some implementations, if check encoding such as cyclic redundancy check (cyclic redundancy check, CRC) is performed on the information bit sequence, K may alternatively be equal to the length of the information bit sequence plus a length of a check encoded bit sequence (for example, a CRC bit sequence) obtained through check encoding.

Still using an example in which N=8, E=2, and K=3, S2=K-E=1, and S1=N-K-E-S2=2. Refer to FIG. 8. The last three (K=3) second bit positions (x4, x5, and x6) other than two shortened bit positions and one punctured bit position in the N second bit positions may be determined as system bit positions.

In another possible implementation, a bit inverse order (bit inverse order, BIV) rule or the like may be further used, to determine the first K second bit positions other than the S1 shortened bit positions and the S2 punctured bit positions in the N second bit positions as system bit positions. Still using an example in which N=8, E=2, and K=3, S2=K-E=1, and S1=N-K-E-S2=2. 0 to 7 are respectively 000, 001, 010, 011, 100, 101, 110, and 111 obtained through binary expansion, and 000, 100, 010, 110, 001, 101, 011, and 111 are obtained through bit inversion (bit inversion) performed on binary bits. Originally corresponding eight bit position indexes 7, 3, 5, 1, 6, 2, 4, and 0 are extracted in descending order based on a sequence, bit position indexes 0, 3, and 7 of two shortened bit positions and one punctured bit position are removed, and second bits (x5, x1, and x6) corresponding to the first three bit position indexes (5, 1, and 6) are selected as system bit positions.

In a possible implementation, for the frozen bit position in B, first bit positions that are in the N first bit positions and that correspond to the S1 shortened bit positions and the S2 punctured bit positions, and E first bit positions selected based on channel reliability or code reselection may be determined as frozen bit positions. Still using an example in which N=8, E=2, and K=3, S2=K-E=1, and S1=N-K-E-S2=2. Refer to FIG. 8. First bit positions (u0, u3, and u7) that are in the N first bit positions and whose bit position indexes are the same as those of the two shortened bit positions and the punctured bit position, and two first bit positions (u1 and u4) with lowest channel reliability other than u0, u3, and u7 are determined as frozen bit positions.

Still using N=8, E=2, and K=3 as an example, S2=K-E=1, and S1=N-K-E-S2=2. Still refer to FIG. 8. In this embodiment of this application, three (that is, K) second bit positions (x4, x5, and x6) that are in the N second bit positions and whose bit position indexes are 4, 5, and 6 are determined as system bit positions in the systematic polar code, and five (that is, N-K) second bit positions (x0, x1, x2, x3, and x7) whose bit position indexes are 0, 1, 2, 3, and 7 are determined as non-system bit positions in the systematic polar code. Further, it may be determined that the system bit position set A of the systematic polar code is {x4, x5, x6}, and the non-system bit position set $M^A$ of the systematic polar code is {x0, x1, x2, x3, x7}.

In addition, the first bit positions (u0, u3, and u7) that are in the N first bit positions and that correspond to the S1 shortened bit positions and the S2 punctured bit positions, and the E (E=2) first bit positions (u1 and u4) selected based on the channel reliability or the code reselection may be determined as frozen bit positions. Further, the frozen bit position set B of the systematic polar code is {u0, u1, u3, u4, u7}, and the non-frozen bit position set $M^B$ is {u2, u5, u6}. The bit position index intersection set of B and A is 4, and it may be determined that the frozen bit position subset C is {u4}. The bit position index intersection set of $M^B$ and $M^A$ is 2, and it may be determined that the non-frozen bit position subset D is {u2}. A frozen bit position u4 in C and a non-frozen bit position u2 in D are mapped to each other.

In addition, it should be understood that for joint source-channel coding, bits corresponding to the K system bit positions in the systematic polar code are not sent through a channel, and a corresponding LLR is calculated during decoding based on a prior distribution of a source that generates the information bit sequence. This is equivalent to a case in which this part of bits pass through a binary transfer channel with an error probability of P, where P is a probability that each element in the source is 0, and may also be referred to as a source prior probability of the source. Therefore, when source prior probabilities P of sources are distributed differently, determined reliability of N polarized channels (for example, reliability of the N polarized channels determined through density evolution) is also different. Therefore, the E first bit positions selected based on the channel reliability may also be different due to different source prior probabilities corresponding to the K system bit positions.

A setting manner in which neither E nor K is greater than N/2, the N second bit positions in the systematic polar code are divided into the first N/2 second bit positions and the last N/2 second bit positions, the first S2 (max(K-E, 0)) bit positions in the first N/2 second bit positions are set as the punctured bit positions, the bit positions other than the first S2+E bit positions in the first N/2 second bit positions are set as the shortened bit positions, the last N/2-K bit positions in the last N/2 second bit positions are set as the shortened bit positions, and the first K bit positions in the last N/2 second bit positions are set as system bit positions is still used as an example. In this case, there are E first bit positions that do not correspond to the punctured bit positions or the shortened bit positions in the first N/2 first bit positions in the systematic polar code, and there are K first bit positions that do not correspond to the punctured bit positions or the shortened bit positions in the last N/2 first bit positions, where K/E is equal to the code rate R. For the E+K first bit positions, reliability of polarized channels corresponding to the E+K first bit positions determined at different source prior probabilities P is also different. Therefore, different code rates R and different source prior probabilities P may cause, on the E+K first bit positions, different distribution ratios of K non-frozen bit positions (that is, $M^B$) determined based on the channel reliability. Therefore, in this embodiment of this application, a distribution ratio R1/R2 of the K non-frozen bit positions (that is, $M^B$) in the E+K first bit positions at different code rates R and different source prior probabilities P may be preconfigured, and B, $M^B$, C, and D are determined based on the distribution ratio R1/R2.

Table 1 is an example table of distribution ratios, at different code rates R and different source prior probabilities P, of the non-frozen bit positions in the first E first bit positions (equivalent to the first N/2 first bit positions) that do not correspond to the punctured bit positions or the shortened bit positions in the systematic polar code and the last K first bit positions (equivalent to the last N/2 first bit positions) that do not correspond to the punctured bit positions or the shortened bit positions in the systematic polar code provided in this embodiment of this application, where R represents a code rate, and a value may be 0.5, 0.75, 1, 1.25, 1.5, or the like; P represents the source prior probability, and a value may be 0.1, 0.2, 0.3, 0.4, or the like; and R1/R2 represents the distribution ratio of the non-frozen bit positions in the first N/2 first bit positions and the last N/2 first bit positions in the systematic polar code.

It should be understood that Table 1 is merely an example, and values of P, R, and the like in Table 1 are not limited in this application. When the values of R and P are different, R1/R2 (that is, R1 and R2) may be the same or may be different. The K non-frozen bit positions (that is, $M^B$) may be determined based on different values of R and P, and is determined based on distribution of the first N/2 first bit positions and distribution of the last N/2 first bit positions in the systematic polar code, where R1+R2=1.

## Table 1

| P \ R | 0.5 | 0.75 | 1 | 1.25 | 1.5 |
|---|---|---|---|---|---|
| 0.1 | R1/R2 | R1/R2 | R1/R2 | R1/R2 | R1/R2 |
| 0.2 | R1/R2 | R1/R2 | R1/R2 | R1/R2 | R1/R2 |
| 0.3 | R1/R2 | R1/R2 | R1/R2 | R1/R2 | R1/R2 |
| 0.4 | R1/R2 | R1/R2 | R1/R2 | R1/R2 | R1/R2 |

In an example, if P is 0.2, and R is 1.5, R1 is 1/3, R2 is 2/3, and K is 3. In this way, the K non-frozen bit positions (that is, $M^B$) may be obtained, where a quantity K1 of the first N/2 first bit positions distributed in the systematic polar code is equal to 1, and a quantity K2 of the last N/2 first bit positions distributed in the systematic polar code is equal to 2.

Based on a channel reliability sequence Q1 corresponding to the first N/2 first bit positions and a channel reliability sequence Q2 corresponding to the last N/2 first bit positions in the case of P, K1 first bit positions (denoted as a bit position set M1) with highest reliability other than the first bit positions corresponding to the punctured bit positions and the shortened bit positions are selected from the first N/2 first bit positions, and K2 first bit positions (denoted as a bit position set M2) with highest reliability other than the first bit positions corresponding to the punctured bit positions and the shortened bit positions are selected from the last N/2 first bit positions. In this case, a union set of M1 and M2 is the K non-frozen bit positions (that is, $M^B$), and first bit positions other than $M^B$ in the N first bit positions are the N-K frozen bit positions (that is, B).

In addition, a set of first bit positions corresponding to the punctured bit positions and the shortened bit positions in the first N/2 first bit positions and the last N/2 first bit positions may be denoted as a set Q. Mutual mapping is performed on non-frozen bit positions in M1 and frozen bit positions other than bit positions in Q and M2 in the last N/2 first bit positions, where M1 is equivalent to the non-frozen bit position subset D, and the frozen bit positions other than the bit positions located in Q and M2 in the last N/2 first bit positions are equivalent to the frozen bit position subset C.

In this embodiment of this application, that a frozen bit position in C and a non-frozen bit position in D are mapped to each other may be that values of frozen bit positions in C and values of non-frozen bit positions in D are the same in one-to-one correspondence in a sequence. Alternatively, a value of the frozen bit position in C and a value of the non-frozen bit position in D may be mapped to each other by using a mapping matrix Y. This may be represented as D=YC, where Y is a binary matrix (binary matrix). Y may be an Nc-dimensional (that is, Nc*Nc) full rank matrix or unit matrix, and $N_C$ is equal to a quantity of frozen bit positions in C. In this case, the frozen bit positions in C and the non-frozen bit positions in D are the same in one-to-one correspondence in the sequence. In some implementations, Y may alternatively be an Nc-dimensional permutation matrix. In this case, the frozen bit positions in C and the non-frozen bit positions in D may not be the same in one-to-one correspondence in the sequence.

In addition, the foregoing uses an example in which the S1 shortened bit positions and the S2 punctured bit positions are first determined, and then A, B, $M^A$, and $M^B$ are determined. In some possible implementations, A, B, $M^A$, and $M^B$ may alternatively be first determined, and then, the S1 shortened bit positions and the S2 punctured bit positions are determined in $M^A$. In an example, the last K second bit positions in the N second bit positions may be used as A, N-K first bit positions with lowest channel reliability are selected as B based on the channel reliability, to further determine $M^A$ and $M^B$, and the S1 shortened bit positions and the S2 punctured bit positions are determined in $M^A$ according to a specific rule (for example, from front to back or from back to front). This is not limited in embodiments of this application.

In a possible implementation, the performing polar encoding on the information bit sequence, to determine an encoded bit sequence may be implemented based on the following steps.

Step A1: Determine a first intermediate encoded bit sequence based on the information bit sequence and a first polarization transformation submatrix, where the first polarization transformation submatrix is a polarization transformation submatrix corresponding to A in the polarization transformation matrix. In other words, the first polarization transformation submatrix is a submatrix that is in the polarization transformation matrix and that corresponds to rows of bit position indexes of the second bit positions in A.

Step A2: Determine a second intermediate encoded bit sequence based on the first intermediate encoded bit sequence, a mutual mapping relationship between the frozen bit position in C and the non-frozen bit position in D, and a bit position index intersection set of B and $M^A$, where a length of the second intermediate encoded bit sequence is equal to a quantity of second bit positions included in $M^A$.

Step A3: Determine the encoded bit sequence based on the second intermediate encoded bit sequence, a second polarization transformation submatrix, and the information bit sequence, where the second polarization transformation submatrix is a polarization transformation submatrix corresponding to $M^A$ in the polarization transformation matrix. In other words, the second polarization transformation submatrix is a submatrix that is in the polarization transformation matrix and that corresponds to rows of bit position indexes of the second bit positions in $M^A$.

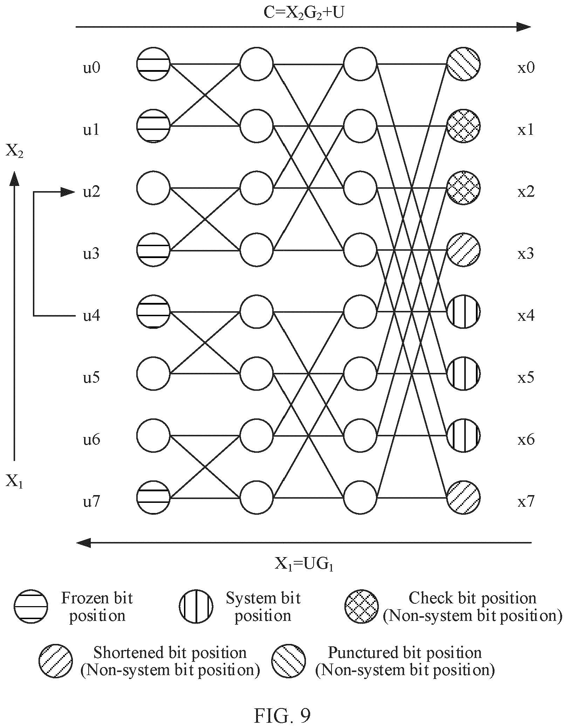

Still using the systematic polar code shown in FIG. 8 as an example, polar encoding is performed on the information bit sequence, to determine that the encoded bit sequence can be implemented with reference to FIG. 9. Step A1: The encoding device obtains a first intermediate encoded bit sequence $X_1$ through multiplication of an information bit sequence U (corresponding to a bit carried in A, which may also be referred to as a value corresponding to A) and a first polarization transformation submatrix $G_1$ obtained from rows that are in a polarization transformation matrix G and that correspond to bit position indexes of second bit positions in A, where $X_1$ corresponds to bits carried in u4 to u6.

Step A2: The encoding device may determine, based on a mutual mapping relationship between the frozen bit position u4 in C and the non-frozen bit position u2 in D and a bit carried in corresponding u4 in $X_1$, a bit carried in u2, and may determine, based on a bit position index intersection set {0, 1, 3, 7} of B {u0, u1, u3, u4, u7} and $M^A$ {x0, x1, x2, x3, x7}, that u0, u1, u3, and u7 carry frozen bits. That a value of a frozen bit is 0 is used as an example. In this case, a second intermediate encoded bit sequence $X_2$ may be obtained, where $X_2$=[0, 0, u2, 0, 0].

Step A3: The encoding device obtains an intermediate check bit sequence $C_1$ through multiplication of $X_2$ and a second polarization transformation submatrix $G_2$ obtained from rows that are in the polarization transformation matrix G and that correspond to bit position indexes of second bit positions in $M^A$, and performs an exclusive OR operation on the intermediate check bit sequence $C_1$ and the information bit sequence U to obtain a check bit sequence C, where C corresponds to bits carried in x1 to x3 and x7. C (corresponding to x1 to x3 and x7) and U (corresponding to x4 to x6) are spliced, to obtain an encoded bit sequence whose length is N.

It should be understood that, when an exclusive OR operation is performed on $C_1$ and U, a principle of performing an exclusive OR operation on a bit whose corresponding bit position index is 0 and a bit whose corresponding bit position index is N/2, performing an exclusive OR operation on a bit whose corresponding bit position index is 1 and a bit whose corresponding bit position index is N/2+1, ..., and performing an exclusive OR operation on a bit whose corresponding bit position index is N/2-1 and a bit whose corresponding bit position index is N-1 may be followed.

For example, an exclusive OR operation is performed on an intermediate check bit corresponding to x0 in $C_1$ and an information bit corresponding to x4 in U, to obtain a check bit corresponding to x0 in the check bit sequence C; an exclusive OR operation is performed on an intermediate check bit corresponding to x1 in $C_1$ and an information bit corresponding to x5 in U, to obtain a check bit corresponding to x1 in the check bit sequence C; an exclusive OR operation is performed on an intermediate check bit corresponding to x2 in $C_1$ and an information bit corresponding to x6 in U, to obtain a check bit corresponding to x2 in the check bit sequence C; an exclusive OR operation is performed on an intermediate check bit corresponding to x3 in $C_1$ and an intermediate check bit corresponding to x7, to obtain a check bit corresponding to x3 in the check bit sequence C; and an exclusive OR operation is performed on the intermediate check bit corresponding to x7 in $C_1$ and the intermediate check bit corresponding to x3, to obtain a check bit corresponding to x7 in the check bit sequence C.

The foregoing is described by using an example in which when K+E is not equal to N, the encoding device needs to perform rate matching. In some implementations, if K+E is equal to N, the encoding device may not perform rate matching; in other words, the encoding device performs rate matching, and shortened bit positions and punctured bit positions determined through shortening and/or puncturing processing are empty. To be specific, the quantity S1 of shortened bit positions is equal to 0, and the quantity S2 of punctured bit positions is equal to 0.

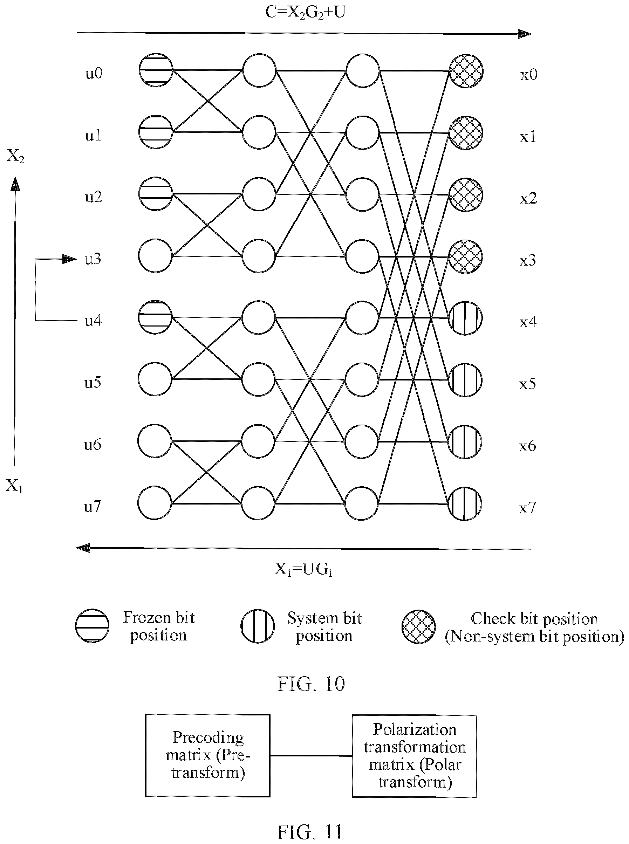

For example, N=8 and K=E=4. As shown in FIG. 10, the last four (K=4) second bit positions (x4, x5, x6, and x7) in the N second bit positions may be determined as system bit positions. A reliability sequence M=[0, 1, 2, 4, 3, 5, 6, 7] of eight polarized channels sorted based on channel reliability is used as an example. In this case, four first bit positions (u0, u1, u2, and u4) that have lowest reliability and whose bit position indexes are 0, 1, 2, and 4 in the N first bit positions may be determined as frozen bit positions in the systematic polar code. It can be learned that, A is {x4, x5, x6, x7}, $M^A$ is {x0, x1, x2, x3}, B is {u0, u1, u2, u4}, $M^B$ is {u3, u5, u6, u7}, C is {u4}, and D is {u3}. The frozen bit position u4 in C and the non-frozen bit position u3 in D are mapped to each other. When N=8 and K=E=4, polar encoding may still be performed on the information bit sequence through the foregoing steps A1 to A3, to determine the encoded bit sequence. For a specific encoding process, refer to the foregoing example. Details are not described again.

Encoding complexity of performing polar encoding on the information bit sequence based on the systematic polar code, to determine the encoded bit sequence does not exceed K(log2N-1)+(N-K)(log2N-1)+N, where K(log2N-1) corresponds to encoding complexity in step 1, and encoding complexity corresponding to step 3 does not exceed (N-K)(log2N-1)+N, where encoding complexity of the exclusive OR operation performed on $C_1$ and U in step 3 does not exceed N, and the mapping between the bit positions in step 2 does not involve encoding complexity.

The foregoing example in which N=8 and K=E=4 is still used. In FIG. 10, encoding complexity of polar encoding performed through the foregoing steps A1 to A3 is 4log2(4)+4*log2(4)+8=8*$\log_2$(8); complexity of the two non-systematic code encoding processes shown in FIG. 6 is 2*8*$\log_2$(8); and the encoding complexity in this embodiment of this application is 1/2 of that of the two non-systematic code encoding processes.

It should be understood that an encoding manner used for encoding the systematic polar code is not limited in embodiments of this application, and an encoding manner such as serial encoding may also be used to implement encoding.

The systematic polar code is not optimized for a code spectrum. As a result, performance of a short code (with a small code length N) is poor. To resolve this problem, in this embodiment of this application, a check code, a convolutional code (conventional code), or the like may be further concatenated before the systematic polar code, to improve the performance of the systematic polar code. Different encoding forms such as the convolutional code may be unified as pre-transform (pre-transform) corresponding to a precoding matrix, and different encoding forms correspond to different precoding matrices. FIG. 11 is a diagram of a pre-transformed systematic polar code. A precoding matrix may be concatenated to a polarization transformation matrix of the systematic polar code, and encoding is performed by using pre-transformation corresponding to the precoding matrix and polar transformation (polar transform) corresponding to the polarization transformation matrix, so that a BER is reduced, and performance of the systematic polar code is improved.

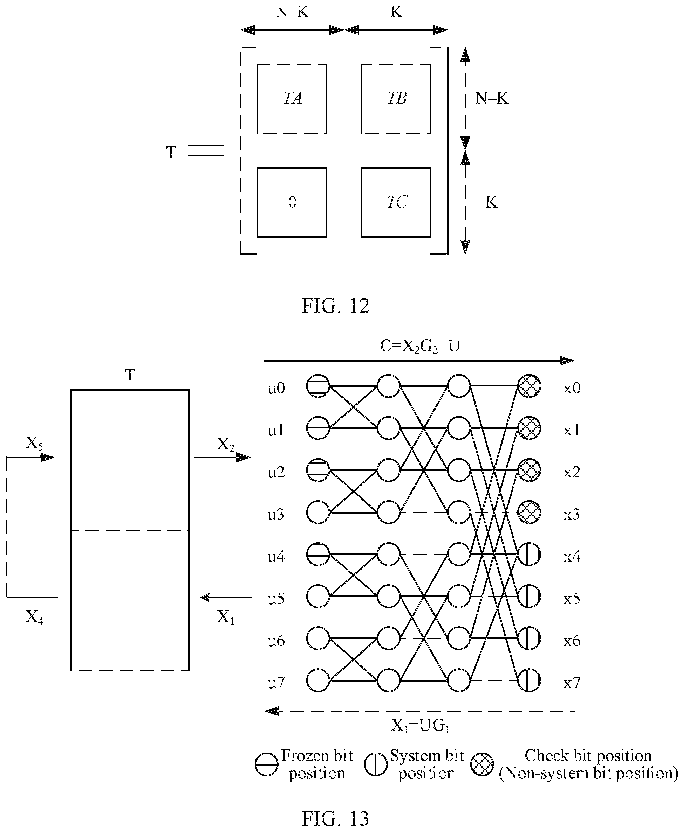

In this embodiment of this application, the precoding matrix may be an N-dimensional upper triangular matrix. In other words, the upper triangular matrix includes N rows and N columns, where N is a code length of the systematic polar code. In an example, when system bit positions are the last K second bit positions in N second bit positions, the N-dimensional upper triangular matrix may be shown in FIG. 12, and the N-dimensional upper triangular matrix T may be

represented as $\begin{bmatrix} TA & TB \\ 0 & TC \end{bmatrix}$, where quantities of rows of TA and TB are determined based on a quantity of non-system bit positions in $M^A$, a quantity of rows of TC is determined based on a quantity of system bit positions in A, a quantity of columns of TA is determined based on a quantity of non-system bit positions in $M^A$, and quantities of columns of TB and TC are determined based on a quantity of system bit positions in A. That is, the quantities of rows of TA and TB are N-K, quantities quantity of rows of 0 and *TC* are K, quantities of columns of 0 and *TA* are K, quantities of columns of *TA* and *TB* are N-K, and 0 represents a matrix whose elements are all 0.

Specifically, the performing polar encoding on the information bit sequence based on the systematic polar code, to determine an encoded bit sequence may be implemented based on the following steps.

Step B1: Determine a first intermediate encoded bit sequence based on the information bit sequence and a first polarization transformation submatrix, where the first polarization transformation submatrix is a polarization transformation submatrix corresponding to A in the polarization transformation matrix. In other words, the first polarization transformation submatrix is a submatrix that is in the polarization transformation matrix and that corresponds to rows of bit position indexes of the second bit positions in A.

Step B2: Determine a fourth intermediate encoded bit sequence based on the first intermediate encoded bit sequence, *TC,* and *TB.*

Step B3: Determine a fifth intermediate encoded bit sequence based on the fourth intermediate encoded bit sequence, a mutual mapping relationship between the frozen bit position in C and the non-frozen bit position in D, and a bit position index intersection set of B and $M^A$.

Step B4: Determine a second intermediate encoded bit sequence based on the fifth intermediate encoded bit sequence and *TA.*

Step B5: Determine the encoded bit sequence based on the second intermediate encoded bit sequence, a second polarization transformation submatrix, and the information bit sequence, where the second polarization transformation submatrix is a polarization transformation submatrix corresponding to $M^A$ in the polarization transformation matrix. In other words, the second polarization transformation submatrix is a submatrix that is in the polarization transformation matrix and that corresponds to rows of bit position indexes of the second bit positions in $M^A$.

For implementations of steps B1 and B5, refer to implementations of steps A1 and A3. Details are not described again.

FIG. 13 is an example of concatenating the systematic polar code shown in FIG. 10 to a precoding matrix T according to an embodiment of this application. T is shown in FIG. 12, $X_1$ represents a first intermediate encoded sequence, $X_2$ represents a second intermediate encoded sequence, $X_4$ represents a fourth intermediate encoded sequence, $X_5$ represents a fifth intermediate encoded sequence, where $X_1$ and $X_2$ may be mutually converted with $X_4$ and $X_5$ by using the pre-transformation matrix T.

Step B2: Because $[X_4 X_5]T=[X_1 X_2]$, that is, $[X_5 TB+X_4 TC]=X_1$, and because u4 and u3 are mapped to each other, $X_5$ may be determined based on $X_4$. For example, a value of u4 and a value of u3 are the same in one-to-one correspondence, and a value corresponding to u3 in $X_5$ may be equal to a value corresponding to u4 in $X_4$, that is, a value whose bit position index is 3 in $X_5$ may be equal to a value whose bit position index is 4 in $X_4$, so that $[X_5 TB+X_4 TC]=X_1$

may be converted into $X_4[TC+\widetilde{TB}]=X_1$, where

$$\widetilde{TB}$$

represents that

$$\widetilde{TB}$$

is formed based on a row corresponding to a bit position index in the set D in *TB* and a zero matrix, that is, a matrix constructed based on a row corresponding to u3 in *TB* and the zero matrix. Therefore, the fourth intermediate encoded bit sequence $X_4$ may be determined based on the first intermediate encoded bit sequence $X_1$, *TC,* and *TB.*

Step B3: A value whose corresponding bit position index is 3 in $X_5$ may be determined based on a mutual mapping relationship between the frozen bit position u4 in C and the non-frozen bit position u3 in D. For example, the mutual mapping relationship is that the value of u4 and the value of u3 are the same in one-to-one correspondence. The value whose corresponding bit position index is 3 in $X_5$ may be set to be the same as the value whose corresponding bit position index is 4 in $X_4$. With reference to a bit position index intersection set {0, 1, 2} of B (u0, u1, u2, and u4) and $M^A$ (x0, x1, x2, and x3), $X_5$ may be obtained, where $X_5=[0, 0, 0, X_4(4)]$. $X_4(4)$ is the value whose corresponding bit position index is 3 in $X_5$ and that is determined based on the value whose bit position index is 4 in $X_4$ and the foregoing mutual mapping relationship. For example, when the mutual mapping relationship is that the value of u4 and the value of u3 are the same in one-to-one correspondence, $X_4(4)$ is the value whose corresponding bit position index is 4 in $X_4$.

Step B4: Multiply $X_5$ by A to obtain $X_2$.

Go back to S703 in FIG. 7: The encoding device performs rate matching on the encoded bit sequence to obtain a target encoded bit sequence.

A length of the target encoded bit sequence is E, and a set of bit positions in the target encoded bit sequence is a subset of $M^A$. Specifically, the set of the bit positions in the target encoded bit sequence is a set of bit positions other than the shortened bit positions and the punctured bit positions in $M^A$. When $M^A$ does not include the shortened bit positions or the punctured bit positions, the set of the bit positions in the target encoded bit sequence is $M^A$.

Specifically, the encoding device removes encoded bits corresponding to A, the shortened bit positions, and the punctured bit positions from the encoded bit sequence, to obtain the target encoded bit sequence, that is, obtain a bit sequence corresponding to check bit positions.

For example, as shown in FIG. 9, it is assumed that the encoded bit sequence is [0, 1, 0, 0, 0, 1, 1, 0], and corresponds to N second bit positions, where in the N second bit positions, A is x4, x5, and x6, and the shortened bit positions are x3 and x7. If a punctured bit position is x0, the encoding device may remove bits corresponding to x0, x3, x4, x5, x6, and x7 from the encoded bit sequence [0, 1, 0, 0, 0, 1, 1, 0], to obtain a target encoded bit sequence [1, 0].

Similarly, as shown in FIG. 10, it is assumed that the encoded bit sequence is [0, 1, 0, 0, 0, 1, 1, 0], and corresponds to N second bit positions, where in the N second bit positions, A is x4, x5, x6, and x7. If neither the shortened bit positions nor the punctured bit positions exist, the encoding device may remove bits corresponding to x4, x5, x6, and x7 from the encoded bit sequence [0, 1, 0, 0, 0, 1, 1, 0], to obtain a target encoded bit sequence [0, 1, 0, 0].

S704: The encoding device outputs the target encoded bit sequence, and correspondingly, the decoding device obtains a to-be-decoded symbol sequence.

A modulated symbol is obtained by modulating the target encoded bit sequence at a transmitter, and the modulated symbol is received by the decoding device after being transmitted through a channel. The decoding device demodulates the received modulated symbol to obtain the to-be-decoded symbol sequence, where the to-be-decoded symbol sequence corresponds to the target encoded bit sequence, and is usually obtained by transforming the target encoded bit sequence due to interference from a factor such as noise in the channel. In other words, the to-be-decoded symbol sequence may be understood as a target encoded bit sequence that is interfered with by the channel or the like.

S705: The decoding device performs polar decoding on the to-be-decoded symbol sequence based on the code rate R or the length K of the information bit sequence and an LLR corresponding to a system bit position, to determine the information bit sequence.

For an implementation of how the decoding device determines A, $M^A$, B, $M^B$, C and D, and the related S1 shortened bit positions and/or S2 punctured bit positions, refer to an implementation on an encoding device side. Details are not described again.

In this embodiment of this application, decoding may be performed in a decoding manner that may be used for the systematic polar code, such as SC decoding or SCL decoding.

Specifically, the decoding device may first determine a first intermediate decoded bit sequence based on the to-be-decoded symbol sequence, the LLR corresponding to the information bit position, the polarization transformation matrix, the mutual mapping relationship between the frozen bit position in C and the non-frozen bit position in D, and the bit position index intersection set of B and $M^A$. Then, the decoding device may determine the information bit sequence based on the first intermediate decoded bit sequence and the polarization transformation matrix.

It should be understood that the value of the non-frozen bit position in D is first decoded during decoding, and the value of the frozen bit position in C is determined based on the value of the non-frozen bit position in D. For example, D is {u2}, and C is {u4}. In a decoding process, u2 is first decoded, and when u4 is decoded, because u2 and u4 are mapped to each other, u4 may be determined based on u2, and u4 may be directly considered as a frozen bit. In a subsequent example, descriptions are provided based on a case in which that u2 and u4 are mapped to each other means that a value of u2 is equal to the value of u4.

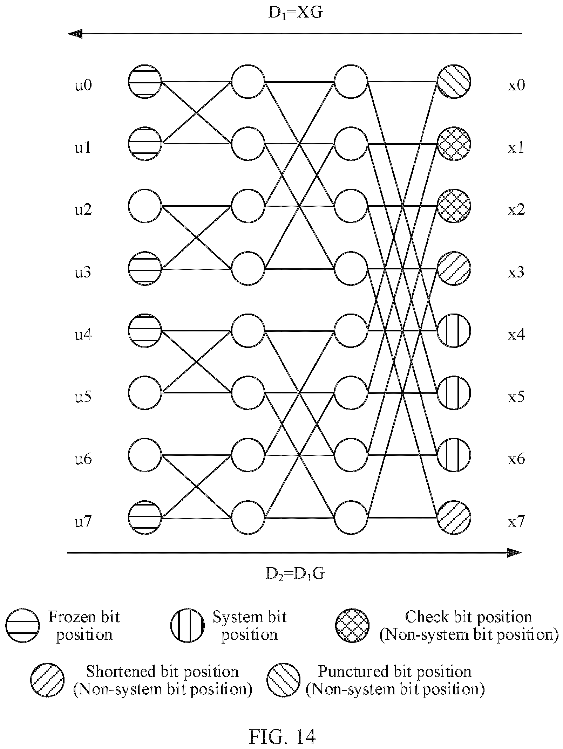

An example in which N=8, E=2, K=3, S2=K-E=1, and S1=N-K-E-S2=2 is used. Refer to FIG. 14. The decoding device may first determine a target to-be-decoded symbol sequence X (corresponding to values of x0 to x7) based on a to-be-decoded symbol sequence (corresponding to values of x1 and x2), LLRs (corresponding to values of x4 to x6) corresponding to information bit positions, a preset value (corresponding to a value of x0) of a punctured bit position, and a preset value (corresponding to values of x3 and x7) of a shortened bit position. It should be understood that the LLR corresponding to the information bit position may be determined based on a prior probability P of a source used by the encoding device, and LLR=ln(P/(1-P)), where the prior probability P of the source used by the encoding device may be preconfigured in the decoding device, or indicated by the encoding device to the decoding device. For example, the LLR is 0.2. In this case, the values of x4 to x6 may all be 0.2. The preset value of the punctured bit position and the preset value of the shortened bit position may also be preconfigured in the decoding device. For example, the preset value of the punctured bit position may be 0, and the preset value of the shortened bit position may be positive infinity.

After determining the target to-be-decoded symbol sequence X, the decoding device may first determine, by using an SCL decoding method, a first intermediate decoded bit sequence $D_1$, that is, values of u0 to u7, based on the target to-be-decoded symbol sequence X, that is, the values of x0 to x7, and the polarization transformation matrix G. In a decoding process, the value of the frozen bit position (u4) in C needs to be kept equal to the value of the non-frozen bit position (u2) in D, and a value of a frozen bit position other than C in B is an agreed or specified constraint condition of a value of a frozen bit. In addition, a second decoded intermediate sequence $D_2$ may be determined based on a product of $D_1$ that is determined and G. Values corresponding to A (x4 to x6) in $D_2$ are the information bit sequence.

In some implementations, alternatively, a check code such as CRC encoding may be added to the systematic polar code, and a check code bit position such as a CRC bit position is set, to improve decoding reliability. The CRC encoding is used as an example. The decoding device may perform decoding by using a CRC-assisted SCL decoding method. To be specific, decoding is first performed based on the SCL decoding method, to obtain L decoding paths; when the decoding ends, for the L decoding paths, values of bit positions on which CRC encoding is performed are separately determined based on values of CRC bit positions; and a path that succeeds in CRC check is selected from the L decoding paths based on a determining result, and is output as a final decoding result.

It should be understood that if check encoding is performed on the information bit sequence, K may alternatively be equal to the length of the information bit sequence plus a length of a check encoded bit sequence (for example, a CRC bit sequence) obtained through check encoding. A bit position index of a bit position included in A is equal to a sum of a bit position index of a system bit position that actually carries the information bit sequence and a bit position index of a check code bit position (for example, the CRC bit position). The following uses an example in which check encoding is CRC check encoding, the check code bit is a CRC bit, and the check code bit position is a CRC bit position for description.

In a possible implementation, the CRC bit position may be carried on the encoding side, a CRC bit sequence carried in the CRC bit position is obtained by performing CRC check encoding on the information bit sequence, and polar encoding is performed on the obtained CRC bit sequence and the information bit sequence together.

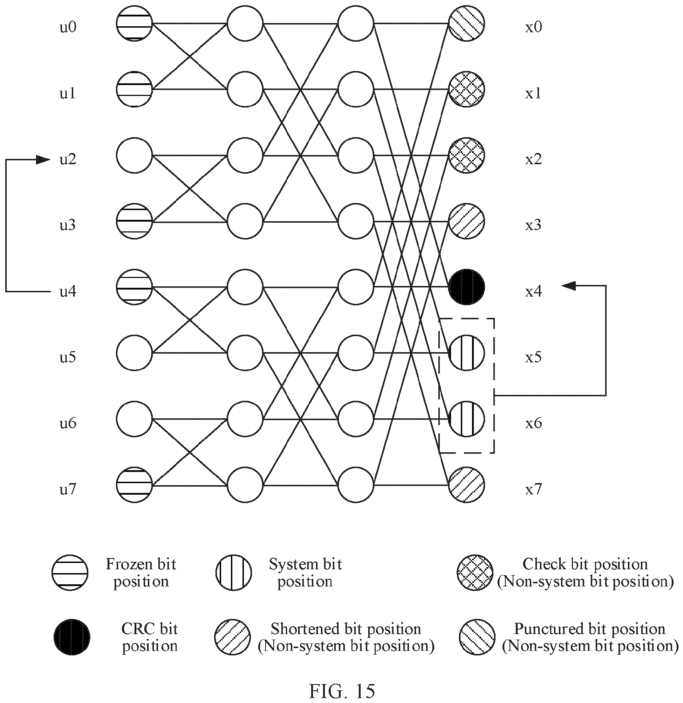

In an example, as shown in FIG. 15, CRC check encoding may be performed on an information bit sequence carried in system bit positions (x5 and x6) that actually carries the information bit sequence, to determine a CRC bit sequence carried in a CRC bit position (x4), that is, a value of the CRC bit position, and the information bit sequence and the CRC bit sequence are used as a new information bit sequence for polar encoding.

During decoding, the value of the CRC bit position x4 (that is, the carried CRC bit sequence) is for checking values of x5 and x6 (that is, the actually carried information bit sequence).

In this implementation, an implementation of check encoding is simple, and an error correction capability for decoding can be improved and decoding reliability can be improved by setting the CRC bit position.

In another possible implementation, the CRC bit position may be located on the to-be-encoded side, and the CRC bit sequence carried in the CRC bit position may be determined based on a non-CRC bit part in a first intermediate encoded bit sequence. For example, the first intermediate encoded bit sequence may include a third intermediate encoded bit sequence and the CRC bit sequence, the third intermediate encoded bit sequence is determined based on an information bit sequence and a first polarization transformation submatrix, and the CRC bit sequence is determined based on the third intermediate encoded bit sequence.

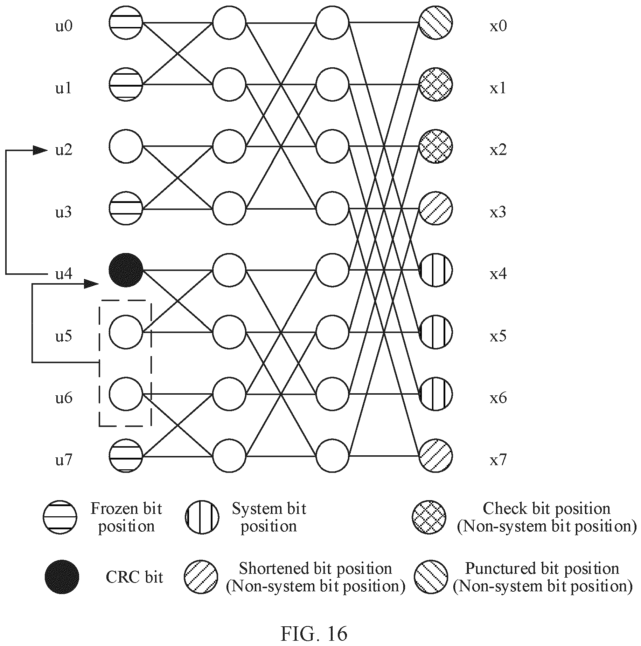

In an example, as shown in FIG. 16, a product of the information bit sequence carried in the system bit positions (x5 and x6) that actually carries the information bit sequence and the first polarization transformation submatrix (rows whose corresponding bit position indexes are 5 and 6 in the first polarization transformation submatrix) may be used to determine the third intermediate encoded bit sequence (corresponding to the values of u5 and u6). CRC check encoding is performed on the third intermediate encoded bit sequence, to determine the CRC bit sequence carried in the CRC bit position (u4), that is, a value of the CRC bit position. The third intermediate encoded bit sequence and the CRC bit sequence are concatenated as the first intermediate encoded sequence to continue polar encoding. A value of a second bit position (that is, a bit position on the encoding side) corresponding to the CRC bit position, for example, a value of x4 in FIG. 16, may be determined based on a product of the CRC bit sequence and a row that is in the first polar encoding submatrix and that corresponds to a bit position index of the CRC bit position.

During decoding, the first intermediate decoded bit sequence includes a second intermediate decoded bit sequence (corresponding to the values of u5 and u6) and the CRC bit sequence (corresponding to the value of u4), and the CRC bit sequence is for checking the second intermediate decoded bit sequence. Bit position indexes (5 and 6) in the second intermediate decoded bit sequence corresponds to bit position indexes (5 and 6) of the information bit sequence in A, and the bit position index (4) in the CRC bit sequence corresponds to a bit position index (4) other than the bit position indexes of the information bit sequence in A.

In this implementation, the CRC bit position is set on the to-be-encoded side (that is, a non-codeword side) of the systematic polar code, and a check relationship is formed between the CRC bit sequence and an encoded bit sequence on the to-be-encoded side. This facilitates early stop of decoding.

In another possible implementation, the CRC bit position may alternatively be located on the to-be-encoded side, and the CRC bit carried in the CRC bit position is obtained by performing check encoding on the information bit sequence. In other words, a first intermediate encoded bit sequence includes a third intermediate encoded bit sequence and a CRC bit sequence, the third intermediate encoded bit sequence is determined based on an information bit sequence and a first polarization transformation submatrix, and the CRC bit sequence is determined based on the information bit sequence.

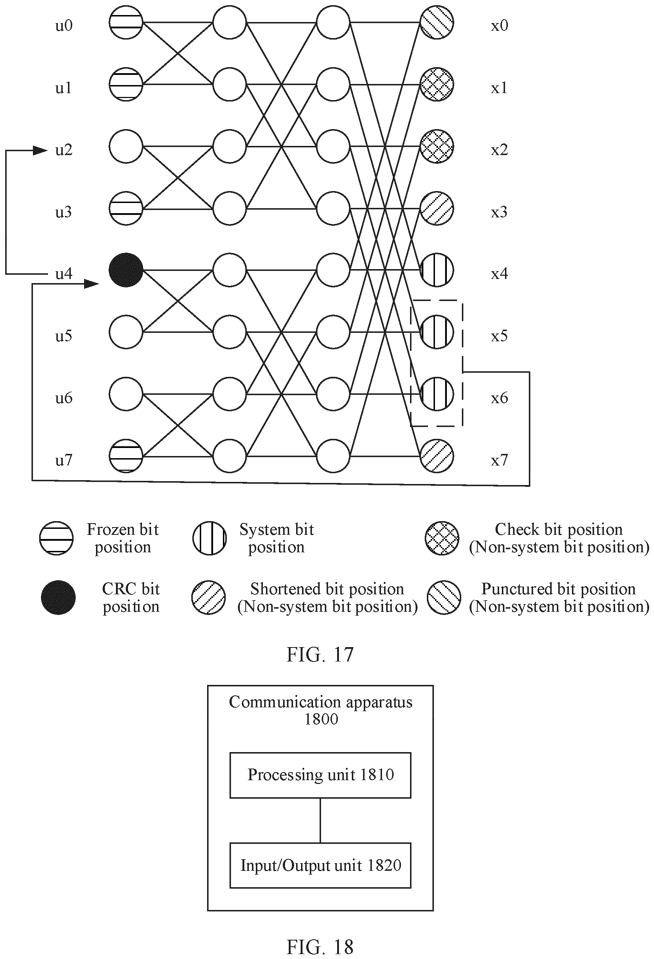

In an example, as shown in FIG. 17, a product of an information bit sequence carried in system bit positions (x5 and x6) that actually carries the information bit sequence and the first polarization transformation submatrix (rows whose corresponding bit position indexes are 5 and 6 in the first polarization transformation submatrix) may be used to determine the third intermediate encoded bit sequence (corresponding to the values of u5 and u6). CRC check encoding is performed on the information bit sequence, to determine the CRC bit sequence carried in the CRC bit position (u4), that is, a value of the CRC bit position. The third intermediate encoded bit sequence and the CRC bit position are concatenated as the first intermediate encoded sequence to continue polar encoding. A value of a second bit position (that is, a bit position on the encoding side) corresponding to the CRC bit position, for example, a value of x4 in FIG. 17, may be determined based on a product of the CRC bit sequence and a row that is in the first polar encoding submatrix and that corresponds to a bit position index of the CRC bit position.

During decoding, the CRC bit sequence (corresponding to the value of u4) in the first intermediate decoded bit sequence is for checking the information bit sequence (that is, values of x5 and x6).

This implementation can balance performance in the foregoing two check encoding settings, and achieve a performance balance between the simple implementation of the check encoding and the early stop of decoding.

It may be understood that, to implement the functions in the foregoing embodiments, the encoding device and the decoding device include corresponding hardware structures and/or software modules for performing the functions. A person skilled in the art should be easily aware that, with reference to the units and method steps in the examples described with reference to embodiments disclosed in this application, this application can be implemented by hardware or a combination of hardware and computer software. Whether a function is performed by hardware or hardware driven by computer software depends on particular application scenarios and design constraint conditions of the technical solutions.

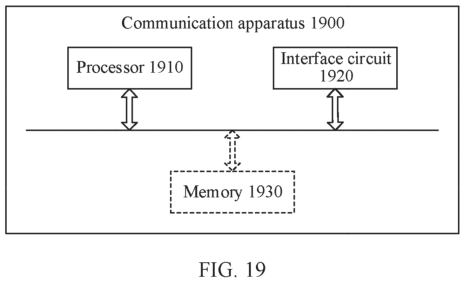

FIG. 18 and FIG. 19 are diagrams of structures of possible communication apparatuses according to embodiments of this application. The communication apparatuses may be configured to implement the functions of the encoding device or the decoding device in the foregoing method embodiments. Therefore, beneficial effects of the foregoing method embodiments can also be achieved.

As shown in FIG. 18, the communication apparatus 1800 includes a processing unit 1810 and an input/output unit 1820. The input/output unit 1820 may alternatively be a transceiver unit, an interface unit, or an input/output interface. The communication apparatus 1800 may be configured to implement the functions of the encoding device or the decoding device in the method embodiment shown in FIG. 7.

When the communication apparatus 1800 is configured to implement the functions of the encoding device in the method embodiment shown in FIG. 7:

the input/output unit 1820 is configured to obtain an information bit sequence, where a length of the information bit sequence is K; the processing unit 1810 is configured to perform polar encoding on the information bit sequence based on a target code length E or a code rate R, to determine an encoded bit sequence, where a systematic polar code on which polar encoding is performed includes a polarization transformation matrix and N first bit positions and N second bit positions that correspond to the polarization transformation matrix; the N second bit positions include a system bit position set A and a non-system bit position set $M^A$, and the N first bit positions include a frozen bit position set B and a non-frozen bit position set $M^B$; there is a frozen bit position subset C in B, there is a non-frozen bit position subset D in $M^B$, and a frozen bit position in C and a non-frozen bit position in D are mapped to each other; C is determined based on a bit position index intersection set of B and A, and D is determined based on a bit position index intersection set of $M^B$ and $M^A$; and A includes K system bit positions, B includes N-K frozen bit positions, a length of the encoded bit sequence is N, and R is equal to K/E; and the processing unit 1810 is further configured to perform rate matching on the encoded bit sequence to obtain a target encoded bit sequence, where a length of the target encoded bit sequence is E, and a set of bit positions in the target encoded bit sequence is a subset of $M^A$.

Optionally, that a frozen bit position in C and a non-frozen bit position in D are mapped to each other includes: the frozen bit position in C and the non-frozen bit position in D are mapped to each other based on a mapping matrix, where the mapping matrix is an $N_C$-dimensional full rank matrix or an $N_C$-dimensional unit matrix, and $N_C$ is equal to a quantity of frozen bit positions in C.

In a possible design, N is a smallest integer power of 2 that is greater than K+E or twice a smallest integer power of 2 that is greater than max(K, E).

In a possible design, the rate matching includes shortening and/or puncturing. Optionally, the N second bit positions include S1 shortened bit positions and/or S2 punctured bit positions, S2 is equal to the larger of K-E and 0, and S1 is equal to N-K-E-S2.

In a possible design, A includes the last K second bit positions other than the S1 shortened bit positions and the S2 punctured bit positions in the N second bit positions; and/or B includes first bit positions that are in the N first bit positions and that correspond to the S1 shortened bit positions and the S2 punctured bit positions, and E first bit positions selected based on channel reliability or code reselection.

In a possible design, when performing polar encoding on the information bit sequence, to determine the encoded bit sequence, the processing unit 1810 is specifically configured to: determine a first intermediate encoded bit sequence based on the information bit sequence and a first polarization transformation submatrix, where the first polarization transformation submatrix is a polarization transformation submatrix corresponding to A in the polarization transformation matrix; determine a second intermediate encoded bit sequence based on the first intermediate encoded bit sequence, a mutual mapping relationship between the frozen bit position in C and the non-frozen bit position in D, and a bit position index intersection set of B and $M^A$, where a length of the second intermediate encoded bit sequence is equal to a quantity of second bit positions included in $M^A$; and determine the encoded bit sequence based on the second intermediate encoded bit sequence, a second polarization transformation submatrix, and the information bit sequence, where the second polarization transformation submatrix is a polarization transformation submatrix corresponding to $M^A$ in the polarization transformation matrix.

In a possible design, that a length of the information bit sequence is K includes: a sum of the length of the information bit sequence and a length of a CRC bit sequence corresponding to information bits is K.

In a possible design, the first intermediate encoded bit sequence includes a third intermediate encoded bit sequence and the CRC bit sequence, the third intermediate encoded bit sequence is determined based on the information bit sequence and the first polarization transformation submatrix, and the CRC bit sequence is determined based on the third intermediate encoded bit sequence.

When the communication apparatus 1800 is configured to implement the functions of the decoding device in the method embodiment shown in FIG. 7:

the input/output unit 1820 is configured to obtain a to-be-decoded symbol sequence, where a length of the to-be-decoded symbol sequence is E; and the processing unit 1810 is configured to perform polar decoding on the to-be-decoded symbol sequence based on a code rate R or a length K of an information bit sequence and a log likelihood ratio LLR corresponding to a system bit position, to determine the information bit sequence, where a systematic polar code on which polar decoding is performed includes a polarization transformation matrix and N first bit positions and N second bit positions that correspond to the polarization transformation matrix; the N second bit positions include a system bit position set A and a non-system bit position set $M^A$, and the N first bit positions include a frozen bit position set B and a non-frozen bit position set $M^B$; there is a frozen bit position subset C in B, there is a non-frozen bit position subset D in $M^B$, and a frozen bit position in C and a non-frozen bit position in D are mapped to each other; C is determined based on a bit position index intersection set of B and A, and D is determined based on a bit position index intersection set of $M^B$ and $M^A$; and A includes K system bit positions, B includes N-K frozen bit positions, and K is equal to ER.

Optionally, that a frozen bit position in C and a non-frozen bit position in D are mapped to each other includes that the frozen bit position in C and the non-frozen bit position in D are mapped to each other based on a mapping matrix, where the mapping matrix is an $N_C$-dimensional full rank matrix or an $N_C$-dimensional unit matrix, and $N_C$ is equal to a quantity of frozen bit positions in C.

In a possible design, N is a smallest integer power of 2 that is greater than K+E or twice a smallest integer power of 2 that is greater than max(K, E).

In a possible design, the N second bit positions include S1 shortened bit positions and/or S2 punctured bit positions, S2 is equal to the larger of K-E and 0, and S1 is equal to N-K-E-S2.

In a possible design, A includes the last K second bit positions other than the S1 shortened bit positions and the S2 punctured bit positions in the N second bit positions; and/or B includes first bit positions that are in the N first bit positions and that correspond to the S1 shortened bit positions and the S2 punctured bit positions, and E first bit positions selected based on channel reliability or code reselection.

In a possible design, when performing polar decoding on the to-be-decoded symbol sequence, to determine the information bit sequence, the processing unit 1810 is specifically configured to: determine a first intermediate decoded bit sequence based on the to-be-decoded symbol sequence, the LLR corresponding to the system bit position, the polarization transformation matrix, a mutual mapping relationship between the frozen bit position in C and the non-frozen bit position in D, and a bit position index intersection set of B and $M^A$; and determine the information bit sequence based on the first intermediate decoded bit sequence and the polarization transformation matrix.

In a possible design, that the length of the information bit sequence is K includes: a sum of the length of the information bit sequence and a length of a CRC bit sequence corresponding to the information bit sequence is K.

In a possible design, the first intermediate decoded bit sequence includes a second intermediate decoded bit sequence and the CRC bit sequence, and the CRC bit sequence is for checking the second intermediate decoded bit sequence, where a bit position index of the second intermediate decoded bit sequence corresponds to a bit position index of the information bit sequence in A, and a bit position index of the CRC bit sequence corresponds to a bit position index other than the bit position index of the information bit sequence in A.

As shown in FIG. 19, the communication apparatus 1900 includes a processor 1910 and an interface circuit 1920. The processor 1910 and the interface circuit 1920 are coupled to each other. It may be understood that the interface circuit 1920 may be a transceiver or an input/output interface. Optionally, the communication apparatus 1900 may further include a memory 1930, configured to: store instructions executed by the processor 1910, or store input data required for running instructions by the processor 1910, or store data generated after the processor 1910 runs instructions. Optionally, the memory 1930 may be integrated with the processor 1910.

When the communication apparatus 1900 is configured to implement the method shown in FIG. 7, the processor 1910 is configured to implement a function of the processing unit 1810, and the interface circuit 1920 is configured to implement a function of the input/output unit 1820.

It may be understood that the processor in embodiments of this application may be a central processing unit (central processing unit, CPU), or may be another general-purpose processor, a digital signal processor (digital signal processor, DSP), an application-specific integrated circuit (application-specific integrated circuit, ASIC), a field programmable gate array (field programmable gate array, FPGA) or another programmable logic device, a transistor logic device, a hardware component, or any combination thereof. The general-purpose processor may be a microprocessor or any conventional processor.

The method steps in embodiments of this application may be implemented in a hardware manner, or may be implemented in a manner of executing software instructions by the processor. The software instructions may include a corresponding software module. The software module may be stored in a random access memory, a flash memory, a read-only memory, a programmable read-only memory, an erasable programmable read-only memory, an electrically erasable programmable read-only memory, a register, a hard disk, a removable hard disk, a CD-ROM, or any other form of storage medium well-known in the art. For example, a storage medium is coupled to a processor, so that the processor can read information from the storage medium and write information into the storage medium. It is clear that the storage medium may be a component of the processor. The processor and the storage medium may be disposed in an ASIC. In addition, the ASIC may be located in a network device or a terminal device. It is clear that the processor and the storage medium may alternatively exist as discrete components in a network device or a terminal device.

All or some of the foregoing embodiments may be implemented by using software, hardware, firmware, or any combination thereof. When software is used to implement embodiments, all or some of embodiments may be implemented in a form of a computer program product. The computer program product includes one or more computer programs or instructions. When the computer programs or instructions are loaded and executed on a computer, procedures or functions in embodiments of this application are all or partially executed. The computer may be a general-purpose computer, a dedicated computer, a computer network, a network device, user equipment, or another programmable apparatus. The computer program or instructions may be stored in a computer-readable storage medium, or may be transmitted from a computer-readable storage medium to another computer-readable storage medium. For example, the computer program or instructions may be transmitted from a website, computer, server, or data center to another website, computer, server, or data center in a wired or wireless manner. The computer-readable storage medium may be any usable medium that can be accessed by the computer, or a data storage device, for example, a server or a data center, integrating one or more usable media. The usable medium may be a magnetic medium, for example, a floppy disk, a hard disk, or a magnetic tape; or may be an optical medium, for example, a digital video disc; or may be a semiconductor medium, for example, a solid-state drive. The computer-readable storage medium may be a volatile or non-volatile storage medium, or may include two types of storage media: a volatile storage medium and a non-volatile storage medium.

In various embodiments of this application, unless otherwise stated or there is a logic conflict, terms and/or descriptions in different embodiments are consistent and may be mutually referenced, and technical features in different embodiments may be combined based on an internal logical relationship thereof, to form a new embodiment.

In addition, it should be understood that the term "for example" in embodiments of this application is used to represent giving an example, an illustration, or a description. Any embodiment or design scheme described as an "example" in this application should not be explained as being more preferred or having more advantages than another embodiment or design scheme. Exactly, the term "example" is used to present a concept in a specific manner.

In addition, in embodiments of this application, information (information), a signal (signal), a message (message), and a channel (channel) may be interchangeably used sometimes. It should be noted that meanings expressed by the terms are consistent when differences of the terms are not emphasized. "Of (of)", "corresponding (corresponding, relevant)", and "corresponding (corresponding)" may sometimes be used interchangeably. It should be noted that meanings expressed by the terms are consistent when differences of the terms are not emphasized.

It may be understood that various numbers in embodiments of this application are merely used for differentiation for ease of description, and are not used to limit the scope of embodiments of this application. Sequence numbers of the foregoing processes do not mean an execution sequence, and the execution sequence of the processes should be determined based on functions and internal logic of the processes.

**Claims**

1. An encoding method, comprising:

   obtaining an information bit sequence, wherein a length of the information bit sequence is K;
   performing polar encoding on the information bit sequence based on a target code length E or a code rate R, to determine an encoded bit sequence, wherein a systematic polar code on which polar encoding is performed comprises a polarization transformation matrix and N first bit positions and N second bit positions that correspond to the polarization transformation matrix; the N second bit positions comprise a system bit position set A and a non-system bit position set $M^4$, and the N first bit positions comprise a frozen bit position set B and a non-frozen bit position set $M^B$; there is a frozen bit position subset C in B, there is a non-frozen bit position subset D in $M^B$, and a frozen bit position in C and a non-frozen bit position in D are mapped to each other; C is determined based on a bit position index intersection set of B and A, and D is determined based on a bit position index intersection set of $M^B$ and $M^A$; and A comprises K system bit positions, B comprises N-K frozen bit positions, a length of the encoded bit sequence is N, and R is equal to K/E; and

performing rate matching on the encoded bit sequence to obtain a target encoded bit sequence, wherein a length of the target encoded bit sequence is E, and a set of bit positions in the target encoded bit sequence is a subset of $M^A$.

2. The method according to claim 1, wherein the rate matching comprises shortening (shortening) and/or puncturing (puncturing).

3. The method according to claim 1 or 2, wherein the N second bit positions comprise S1 shortened bit positions and/or S2 punctured bit positions, S2 is equal to the larger of K-E and 0, and S1 is equal to N-K-E-S2.

4. The method according to claim 3, wherein A comprises the last K second bit positions other than the S1 shortened bit positions and the S2 punctured bit positions in the N second bit positions; and/or
B comprises first bit positions that are in the N first bit positions and that correspond to the S1 shortened bit positions and the S2 punctured bit positions, and E first bit positions selected based on channel reliability or code reselection.

5. The method according to any one of claims 1 to 4, wherein the performing polar encoding on the information bit sequence, to determine an encoded bit sequence comprises:

determining a first intermediate encoded bit sequence based on the information bit sequence and a first polarization transformation submatrix, wherein the first polarization transformation submatrix is a polarization transformation submatrix corresponding to A in the polarization transformation matrix;
determining a second intermediate encoded bit sequence based on the first intermediate encoded bit sequence, a mutual mapping relationship between the frozen bit position in C and the non-frozen bit position in D, and a bit position index intersection set of B and $M^A$, wherein a length of the second intermediate encoded bit sequence is equal to a quantity of second bit positions comprised in $M^A$; and
determining the encoded bit sequence based on the second intermediate encoded bit sequence, a second polarization transformation submatrix, and the information bit sequence, wherein the second polarization transformation submatrix is a polarization transformation submatrix corresponding to $M^A$ in the polarization transformation matrix.

6. The method according to claim 5, wherein that a length of the information bit sequence is K comprises: a sum of the length of the information bit sequence and a length of a cyclic redundancy check CRC bit sequence corresponding to information bits is K.

7. The method according to claim 6, wherein the first intermediate encoded bit sequence comprises a third intermediate encoded bit sequence and the CRC bit sequence, the third intermediate encoded bit sequence is determined based on the information bit sequence and the first polarization transformation submatrix, and the CRC bit sequence is determined based on the third intermediate encoded bit sequence.

8. The method according to any one of claims 1 to 7, wherein that a frozen bit position in C and a non-frozen bit position in D are mapped to each other comprises: the frozen bit position in C and the non-frozen bit position in D are mapped to each other based on a mapping matrix, wherein the mapping matrix is an $N_C$-dimensional full rank matrix or an $N_C$-dimensional unit matrix, and $N_C$ is equal to a quantity of frozen bit positions in C.

9. The method according to any one of claims 1 to 8, wherein N is a smallest integer power of 2 that is greater than K+E or twice a smallest integer power of 2 that is greater than max(K, E).

10. A decoding method, comprising:

obtaining a to-be-decoded symbol sequence, wherein a length of the to-be-decoded symbol sequence is E; and

performing polar decoding on the to-be-decoded symbol sequence based on a code rate R or a length K of an information bit sequence and a log likelihood ratio LLR corresponding to a system bit position, to determine the information bit sequence, wherein a systematic polar code on which polar decoding is performed comprises a polarization transformation matrix and N first bit positions and N second bit positions that correspond to the polarization transformation matrix; the N second bit positions comprise a system bit position set A and a non-system bit position set $M^A$, and the N first bit positions comprise a frozen bit position set B and a non-frozen bit position set $M^B$; there is a frozen bit position subset C in B, there is a non-frozen bit position subset D in $M^B$, and a frozen bit position in C and a non-frozen bit position in D are mapped to each other; C is determined based on a bit position index intersection set of B and A, and D is determined based on a bit position index intersection set of $M^B$ and $M^A$; and A comprises K system bit positions, B comprises N-K frozen bit positions, and K is equal to ER.

11. The method according to claim 10, wherein the N second bit positions comprise S1 shortened (shorten) bit positions and/or S2 punctured (puncture) bit positions, S2 is equal to the larger of K-E and 0, and S1 is equal to N-K-E-S2.

12. The method according to claim 11, wherein A comprises the last K second bit positions other than the S1 shortened bit positions and the S2 punctured bit positions in the N second bit positions; and/or
B comprises first bit positions that are in the N first bit positions and that correspond to the S1 shortened bit positions and the S2 punctured bit positions, and E first bit positions selected based on channel reliability or code reselection.

13. The method according to any one of claims 10 to 12, wherein the performing polar decoding on the to-be-decoded symbol sequence, to determine the information bit sequence comprises:

determining a first intermediate decoded bit sequence based on the to-be-decoded symbol sequence, the LLR corresponding to the system bit position, the polarization transformation matrix, a mutual mapping relationship between the frozen bit position in C and the non-frozen bit position in D, and a bit position index intersection set of B and $M^A$; and
determining the information bit sequence based on the first intermediate decoded bit sequence and the polarization transformation matrix.

14. The method according to claim 13, wherein that the length of the information bit sequence is K comprises: a sum of the length of the information bit sequence and a length of a cyclic redundancy check CRC bit sequence corresponding to the information bit sequence is K.

15. The method according to claim 14, wherein the first intermediate decoded bit sequence comprises a second intermediate decoded bit sequence and the CRC bit sequence, and the CRC bit sequence is for checking the second intermediate decoded bit sequence, wherein a bit position index of the second intermediate decoded bit sequence corresponds to a bit position index of the information bit sequence in A, and a bit position index of the CRC bit sequence corresponds to a bit position index other than the bit position index of the information bit sequence in A.

16. The method according to any one of claims 10 to 15, wherein that a frozen bit position in C and a non-frozen bit position in D are mapped to each other comprises that the frozen bit position in C and the non-frozen bit position in D are mapped to each other based on a mapping matrix, wherein the mapping matrix is an $N_C$-dimensional full rank matrix or an $N_C$-dimensional unit matrix, and $N_C$ is equal to a quantity of frozen bit positions in C.

17. The method according to any one of claims 10 to 16, wherein N is a smallest integer power of 2 that is greater than K+E or twice a smallest integer power of 2 that is greater than max(K, E).

18. A communication apparatus, comprising an input/output unit and a processing unit, wherein

the input/output unit is configured to obtain an information bit sequence, wherein a length of the information bit sequence is K;
the processing unit is configured to perform polar encoding on the information bit sequence based on a target code length E or a code rate R, to determine an encoded bit sequence, wherein a systematic polar code on which polar encoding is performed comprises a polarization transformation matrix and N first bit positions and N second bit positions that correspond to the polarization transformation matrix; the N second bit positions comprise a system bit position set A and a non-system bit position set $M^A$, and the N first bit positions comprise a frozen bit position set B and a non-frozen bit position set $M^B$; there is a frozen bit position subset C in B, there is a non-frozen bit position subset D in $M^B$, and a frozen bit position in C and a non-frozen bit position in D are mapped to each other; C is determined based on a bit position index intersection set of B and A, and D is determined based on a bit position index intersection set of $M^B$ and $M^A$; and A comprises K system bit positions, B comprises N-K frozen bit positions, a length of the encoded bit sequence is N, and R is equal to K/E; and

the processing unit is further configured to perform rate matching on the encoded bit sequence to obtain a target encoded bit sequence, wherein a length of the target encoded bit sequence is E, and a set of bit positions in the target encoded bit sequence is a subset of $M^A$.

19. The apparatus according to claim 18, wherein the rate matching comprises shortening (shortening) and/or puncturing (puncturing).

20. The apparatus according to claim 18 or 19, wherein the N second bit positions comprise S1 shortened bit positions and/or S2 punctured bit positions, S2 is equal to the larger of K-E and 0, and S1 is equal to N-K-E-S2.

21. The apparatus according to claim 20, wherein A comprises the last K second bit positions other than the S1 shortened bit positions and the S2 punctured bit positions in the N second bit positions; and/or

B comprises first bit positions that are in the N first bit positions and that correspond to the S1 shortened bit positions and the S2 punctured bit positions, and E first bit positions selected based on channel reliability or code reselection.

22. The apparatus according to any one of claims 18 to 21, wherein when performing polar encoding on the information bit sequence, to determine the encoded bit sequence, the processing unit is specifically configured to: determine a first intermediate encoded bit sequence based on the information bit sequence and a first polarization transformation submatrix, wherein the first polarization transformation submatrix is a polarization transformation submatrix corresponding to A in the polarization transformation matrix; determine a second intermediate encoded bit sequence based on the first intermediate encoded bit sequence, a mutual mapping relationship between the frozen bit position in C and the non-frozen bit position in D, and a bit position index intersection set of B and $M^A$, wherein a length of the second intermediate encoded bit sequence is equal to a quantity of second bit positions comprised in $M^A$; and determine the encoded bit sequence based on the second intermediate encoded bit sequence, a second polarization transformation submatrix, and the information bit sequence, wherein the second polarization transformation submatrix is a polarization transformation submatrix corresponding to $M^A$ in the polarization transformation matrix.

23. The apparatus according to claim 22, wherein that a length of the information bit sequence is K comprises: a sum of the length of the information bit sequence and a length of a cyclic redundancy check CRC bit sequence corresponding to information bits is K.

24. The apparatus according to claim 23, wherein the first intermediate encoded bit sequence comprises a third intermediate encoded bit sequence and the CRC bit sequence, the third intermediate encoded bit sequence is determined based on the information bit sequence and the first polarization transformation submatrix, and the CRC bit sequence is determined based on the third intermediate encoded bit sequence.

25. The apparatus according to any one of claims 18 to 24, wherein that a frozen bit position in C and a non-frozen bit position in D are mapped to each other comprises: the frozen bit position in C and the non-frozen bit position in D are mapped to each other based on a mapping matrix, wherein the mapping matrix is an $N_C$-dimensional full rank matrix or an $N_C$-dimensional unit matrix, and $N_C$ is equal to a quantity of frozen bit positions in C.

26. The apparatus according to any one of claims 18 to 25, wherein N is a smallest integer power of 2 that is greater than K+E or twice a smallest integer power of 2 that is greater than max(K, E).

27. A communication apparatus, comprising an input/output unit and a processing unit, wherein

the input/output unit is configured to obtain a to-be-decoded symbol sequence, wherein a length of the to-be-decoded symbol sequence is E; and

the processing unit is configured to perform polar decoding on the to-be-decoded symbol sequence based on a code rate R or a length K of an information bit sequence and a log likelihood ratio LLR corresponding to a system bit position, to determine the information bit sequence, wherein a polar code on which polar decoding is performed comprises a polarization transformation matrix and N first bit positions and N second bit positions that correspond to the polarization transformation matrix; the N second bit positions comprise a system bit position set A and a non-system bit position set $M^A$, and the N first bit positions comprise a frozen bit position set B and a non-frozen bit position set $M^B$; there is a frozen bit position subset C in B, there is a non-frozen bit position subset D in $M^B$, and a frozen bit position in C and a non-frozen bit position in D are mapped to each other; C is determined based on a bit position index intersection set of B and A, and D is determined based on a bit position index intersection set of $M^B$ and $M^A$; and A comprises K system bit positions, B comprises N-K frozen bit positions, and K is equal to ER.

28. The apparatus according to claim 27, wherein the N second bit positions comprise S1 shortened (shorten) bit positions and/or S2 punctured (puncture) bit positions, S2 is equal to the larger of K-E and 0, and S1 is equal to N-K-E-S2.

29. The apparatus according to claim 28, wherein A comprises the last K second bit positions other than the S1 shortened bit positions and the S2 punctured bit positions in the N second bit positions; and/or
B comprises first bit positions that are in the N first bit positions and that correspond to the S1 shortened bit positions and the S2 punctured bit positions, and E first bit positions selected based on channel reliability or code reselection.

30. The apparatus according to any one of claims 27 to 29, wherein when performing polar decoding on the to-be-decoded symbol sequence, to determine the information bit sequence, the processing unit is specifically configured to: determine a first intermediate decoded bit sequence based on the to-be-decoded symbol sequence, the LLR corresponding to the system bit position, the polarization transformation matrix, a mutual mapping relationship between the frozen bit position in C and the non-frozen bit position in D, and a bit position index intersection set of B and $M^A$; and determine the information bit sequence based on the first intermediate decoded bit sequence and the polarization transformation matrix.

31. The apparatus according to claim 30, wherein that the length of the information bit sequence is K comprises: a sum of the length of the information bit sequence and a length of a cyclic redundancy check CRC bit sequence corresponding to the information bit sequence is K.

32. The apparatus according to claim 31, wherein the first intermediate decoded bit sequence comprises a second intermediate decoded bit sequence and the CRC bit sequence, and the CRC bit sequence is for checking the second intermediate decoded bit sequence, wherein a bit position index of the second intermediate decoded bit sequence corresponds to a bit position index of the information bit sequence in A, and a bit position index of the CRC bit sequence corresponds to a bit position index other than the bit position index of the information bit sequence in A.

33. The apparatus according to any one of claims 27 to 32, wherein that a frozen bit position in C and a non-frozen bit position in D are mapped to each other comprises: the frozen bit position in C and the non-frozen bit position in D are mapped to each other based on a mapping matrix, wherein the mapping matrix is an $N_C$-dimensional full rank matrix or an $N_C$-dimensional unit matrix, and $N_C$ is equal to a quantity of frozen bit positions in C.

34. The apparatus according to any one of claims 27 to 33, wherein N is a smallest integer power of 2 that is greater than K+E or twice a smallest integer power of 2 that is greater than max(K, E).

35. A communication apparatus, comprising a processor and an interface circuit, wherein the interface circuit is configured to: receive a signal from a communication apparatus other than the communication apparatus and transmit the signal to the processor, or send a signal from the processor to a communication apparatus other than the communication apparatus, and the processor is configured to implement the method according to any one of claims 1 to 9 or the method according to any one of claims 10 to 17 by using a logic circuit or by executing code instructions.

36. A computer program product, comprising program code, wherein when the program code is executed, the method according to any one of claims 1 to 9 is implemented, or the method according to any one of claims 10 to 17 is implemented.

37. A chip, wherein the chip is configured to implement the method according to any one of claims 1 to 9, or configured to implement the method according to any one of claims 10 to 17.

38. A computer-readable storage medium, wherein the storage medium stores a computer program or instructions, and when the computer program or the instructions are executed, the method according to any one of claims 1 to 9 is implemented, or the method according to any one of claims 10 to 17 is implemented.

39. A communication system, wherein the communication system comprises an encoding device and a decoding device, wherein

the encoding device is configured to implement the method according to any one of claims 1 to 9; and
the decoding device is configured to implement the method according to any one of claims 10 to 17.

Network
device

FIG. 1

Source → Joint source-channel coding → Modulation

Modulated symbol

Sink ← Joint source-channel decoding ← Demodulation

FIG. 2

| | | | |
|---|---|---|---|
| Frozen bit position | $u0=0$ | | $x0=0$ |
| Frozen bit position | $u1=0$ | | $x1=1$ |
| Frozen bit position | $u2=0$ | | $x2=0$ |
| Information bit position | $u3=0$ | | $x3=1$ |
| Frozen bit position | $u4=0$ | | $x4=0$ |
| Information bit position | $u5=0$ | | $x5=1$ |
| Information bit position | $u6=1$ | | $x6=0$ |
| Information bit position | $u7=1$ | | $x7=1$ |

FIG. 3

Sorted by PM values

Path width L

FIG. 4

Frozen bit position    System bit position    Check bit position

FIG. 5

FIG. 6

Encoding device

Decoding device

S701: The encoding device obtains an information bit sequence

S702: Perform polar encoding on the information bit sequence based on a target code length E or a code rate R, to determine an encoded bit sequence

S703: Perform rate matching on the encoded bit sequence to obtain a target encoded bit sequence

S704: The encoding device outputs the target encoded bit sequence, and correspondingly, the decoding device obtains a to-be-decoded symbol sequence

S705: Perform polar decoding on the to-be-decoded symbol sequence based on the code rate R or a length K of a system bit sequence and an LLR corresponding to a system bit position, to determine the information bit sequence

FIG. 7

FIG. 8

FIG. 9

$$C = X_2 G_2 + U$$

FIG. 10

FIG. 11

$$N-K \qquad K$$

$$T = \begin{bmatrix} TA & TB \\ 0 & TC \end{bmatrix}$$

FIG. 12

$$C = X_2 G_2 + U$$

$$X_1 = U G_1$$

⊖ Frozen bit position ⊕ System bit position ⊗ Check bit position (Non-system bit position)

FIG. 13

$$D_1 = XG$$

$$D_2 = D_1 G$$

⊖ Frozen bit position    ⦿ System bit position    ⊗ Check bit position (Non-system bit position)

⊘ Shortened bit position (Non-system bit position)    ⊘ Punctured bit position (Non-system bit position)

FIG. 14

u0
u1
u2
u3
u4
u5
u6
u7

x0
x1
x2
x3
x4
x5
x6
x7

⊖ Frozen bit
position

⦀ System bit
position

⊗ Check bit position
(Non-system bit position)

● CRC bit
position

⊘ Shortened bit position
(Non-system bit position)

⊘ Punctured bit position
(Non-system bit position)

FIG. 15

u0
u1
u2
u3
u4
u5
u6
u7

x0
x1
x2
x3
x4
x5
x6
x7

Frozen bit position    System bit position    Check bit position (Non-system bit position)

CRC bit    Shortened bit position (Non-system bit position)    Punctured bit position (Non-system bit position)

FIG. 16

FIG. 17

FIG. 18

Communication apparatus 1900

Processor 1910

Interface circuit 1920

Memory 1930

FIG. 19

<table>
<tr><td colspan="2"><strong>INTERNATIONAL SEARCH REPORT</strong></td><td>International application No.<br><br>**PCT/CN2023/091493**</td></tr>
</table>

**A. CLASSIFICATION OF SUBJECT MATTER**

H03M 13/13(2006.01)i

According to International Patent Classification (IPC) or to both national classification and IPC

**B. FIELDS SEARCHED**

Minimum documentation searched (classification system followed by classification symbols)

H03M

Documentation searched other than minimum documentation to the extent that such documents are included in the fields searched

Electronic data base consulted during the international search (name of data base and, where practicable, search terms used)

VEN, ENTXT, IEEE, CNABS, CNTXT, CNKI: 编码, 译码, 系统极化码, 映射, 冻结, 系统, 索引, 比特位, 矩阵, encoding, coding, systematic polar codes, mapping, freeze, systematic, index, bit, matrix

**C. DOCUMENTS CONSIDERED TO BE RELEVANT**

| Category* | Citation of document, with indication, where appropriate, of the relevant passages | Relevant to claim No. |
|---|---|---|
| A | CN 112886969 A (HUAWEI TECHNOLOGIES CO., LTD.) 01 June 2021 (2021-06-01) description, paragraphs 6-47 | 1-39 |
| A | CN 108696333 A (HUAWEI TECHNOLOGIES CO., LTD.) 23 October 2018 (2018-10-23) entire document | 1-39 |
| A | CN 110034843 A (HUAWEI TECHNOLOGIES CO., LTD.) 19 July 2019 (2019-07-19) entire document | 1-39 |
| A | CN 110233698 A (BEIJING SPREADTRUM HIGH-TECH COMMUNICATIONS TECHNOLOGY CO., LTD.) 13 September 2019 (2019-09-13) entire document | 1-39 |
| A | US 2018026663 A1 (MEDIATEK INC.) 25 January 2018 (2018-01-25) entire document | 1-39 |

☐ Further documents are listed in the continuation of Box C.  ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" document member of the same patent family |
| "P" | document published prior to the international filing date but later than the priority date claimed | |

| Date of the actual completion of the international search | Date of mailing of the international search report |
|---|---|
| **14 June 2023** | **21 June 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

Information on patent family members

International application No.

**PCT/CN2023/091493**

| Patent document cited in search report | | | Publication date (day/month/year) | Patent family member(s) | | | Publication date (day/month/year) |
|---|---|---|---|---|---|---|---|
| CN | 112886969 | A | 01 June 2021 | WO | 2021103978 | A1 | 03 June 2021 |
| | | | | EP | 4050826 | A1 | 31 August 2022 |
| | | | | EP | 4050826 | A4 | 21 December 2022 |
| | | | | US | 2022286144 | A1 | 08 September 2022 |
| CN | 108696333 | A | 23 October 2018 | EP | 3595209 | A1 | 15 January 2020 |
| | | | | EP | 3595209 | A4 | 25 March 2020 |
| | | | | WO | 2018184480 | A1 | 11 October 2018 |
| | | | | US | 2020028619 | A1 | 23 January 2020 |
| | | | | US | 11239945 | B2 | 01 February 2022 |
| | | | | CN | 108696333 | B | 01 October 2021 |
| CN | 110034843 | A | 19 July 2019 | EP | 3734873 | A1 | 04 November 2020 |
| | | | | EP | 3734873 | A4 | 03 March 2021 |
| | | | | EP | 3734873 | B1 | 08 March 2023 |
| | | | | WO | 2019137537 | A1 | 18 July 2019 |
| | | | | US | 2020343913 | A1 | 29 October 2020 |
| | | | | US | 11362677 | B2 | 14 June 2022 |
| | | | | CN | 110034843 | B | 14 June 2022 |
| CN | 110233698 | A | 13 September 2019 | CN | 110233698 | B | 19 November 2021 |
| US | 2018026663 | A1 | 25 January 2018 | EP | 3273603 | A1 | 24 January 2018 |
| | | | | TW | 201813322 | A | 01 April 2018 |
| | | | | TWI | 648956 | B | 21 January 2019 |
| | | | | US | 10432234 | B2 | 01 October 2019 |
| | | | | EP | 3273602 | A2 | 24 January 2018 |
| | | | | EP | 3273602 | A3 | 30 May 2018 |
| | | | | EP | 3273602 | B1 | 26 January 2022 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210564600